(19) Europäisches Patentamt
European Patent Office
Office européen des brevets

(11) EP 2 062 737 A1

(12) EUROPEAN PATENT APPLICATION

(43) Date of publication:
27.05.2009 Bulletin 2009/22

(51) Int Cl.:
*B41N 3/08* *(2006.01)* *G03F 7/40* *(2006.01)*

(21) Application number: 07121115.5

(22) Date of filing: 20.11.2007

(84) Designated Contracting States:
AT BE BG CH CY CZ DE DK EE ES FI FR GB GR HU IE IS IT LI LT LU LV MC MT NL PL PT RO SE SI SK TR
Designated Extension States:
AL BA HR MK RS

(71) Applicant: Eastman Kodak Company
Rochester NY 14650-2201 (US)

(72) Inventors:
- Strehmel, Bernd
13585 Berlin (DE)
- Simpson, Christopher
37520 Osterode (DE)
- Piestert, Oliver
68732 Schwetzingen (DE)
- Baumann, Harald
37520 Osterode (DE)

(74) Representative: Vossius & Partner
Siebertstrasse 4
81675 München (DE)

# (54) Processing of lithographic printing plates with hydrophilic polymer in finisher solution

(57) Process for the production of a lithographic printing plate, comprising
(a) providing a lithographic printing plate precursor comprising (i) a substrate; (ii) a radiation-sensitive coating comprising one or more layers and (iii) optionally an oxygen-impermeable overcoat;
(b) image-wise exposing the lithographic printing plate precursor to radiation of a wavelength to which the radiation-sensitive coating is sensitive;
(c) optionally subjecting the image-wise exposed precursor to a preheat treatment and/or rinsing with water;
(d) removing the non-image areas from the image-wise exposed precursor by means of an alkaline developer solution;
(e) optionally subjecting the imaged precursor obtained in step (d) to rinsing with water;
(f) treating the imaged lithographic printing plate obtained in step (d) or (e) with a finisher solution; and
(g) optionally subjecting the finisher treated plate obtained in step (f) to at least one further process step selected from rinsing with water, drying and baking;

characterized in that the finisher solution comprises 0.01 to 15 wt.%, based on the total weight of the finisher, of a hydrophilic polymer comprising:
(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50.

EP 2 062 737 A1

## Description

The present invention relates to a process for the production of lithographic printing plates, in particular to a process for treating an imaged lithographic printing plate with a finisher solution containing a hydrophilic organic polymer. The invention furthermore relates to lithographic printing plates produced according to this process.

The technical field of lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as "blanket", which then in turn transfers the printing ink onto the surface of the material on which the image is to be formed; this technique is referred to as offset lithography.

Usually, a lithographic printing plate precursor (in this context the term "printing plate precursor" refers to a coated printing plate prior to exposure and developing) comprises a radiation-sensitive coating applied onto a substrate, usually on aluminum basis. If a coating reacts to radiation such that the exposed portion becomes so soluble that it is removed during the developing process, the plate is referred to as "positive working". On the other hand, a plate is referred to as "negative working" if the exposed portion of the coating is hardened by the radiation so that it remains on the substrate during developing. In both cases, the remaining image area accepts printing ink, i.e. is oleophilic, and the non-image area (background) accepts water, i.e. is hydrophilic. The differentiation between image and non-image areas takes place during exposure. Usually, an aqueous alkaline developer whose pH value is usually in the range of 8 to 13.5 is used to remove the more soluble portions of the coating.

Usually, a substrate, in particular an aluminum substrate with aluminum oxide layer, is provided with a hydrophilic protective layer (also referred to as "interlayer") before the radiation-sensitive layer is applied. The interlayer can be applied to one or both sides of the substrate; depending on the amount that is applied, the surface of the side(s) of the substrate can be fully or only partially covered. The hydrophilic layer can for example improve the water acceptance of the (non-printing) background areas of a lithographic printing plate caused by the aluminum oxide layer, or the repulsion of the printing ink in these areas, so that the background areas obtained during printing are as clean as possible. The interlayer is furthermore intended to protect a metallic substrate against corrosion caused by strongly alkaline developers and against permanent adsorption of for example dyes used in the radiation-sensitive layer (what is referred to as "staining"). It has, however, been observed that an interlayer might affect the adhesion of the printing areas to the substrate. If a high print run length with high resolution (i.e. very small printing areas) is required, it might therefore sometimes be desirable to use plates without interlayer.

For a clean printed image it is necessary that the image areas (i.e. the image-wise remaining coating) accept the printing ink well while the non-image areas (i.e. the image-wise exposed substrate, such as e.g. an aluminum substrate) are not supposed to accept the printing ink. In order to protect the image-wise exposed substrate, such as e.g. an aluminum substrate, against finger prints, the formation of aluminum oxide and corrosion, as well as against mechanical damage such as scratches when the printing plate is mounted onto the printing machine, i.e. in order to maintain and possibly improve the hydrophilicity of the non-image areas, the developed printing plate is usually subjected to a "gumming" treatment (also referred to as "finishing"). Gumming a plate before storage or prior to long periods of downtime on the printing machine ensures that the non-image areas remain hydrophilic. During printing, the gumming then has to be able to be removed quickly by the fountain solution used so that the image areas are able to accept ink immediately. Gumming solutions have been known for a long time and are often based on gum arabic (e.g. DE 29 26 645 Al).

US 4,880,555 describes a "finisher" for lithographic printing plates comprising maltodextrin prepared by enzymatic hydrolysis, a polyol, hydrocarbons, a mixture of long-chain alcohol and aminated alcohol sulfate, substituted phenoxypoly(oxyethylene)ethanol and an ethanolamine.

US 4,033,919 describes an aqueous gumming solution comprising a polymer which comprises units derived from acrylamide and 1 to 25 wt.-% of units with carboxy groups. The solution furthermore comprises an acidic material such as phosphonic acid, citric acid and tartaric acid. The documents US 4,143,021 and DE 25 045 94 A1 also describe an aqueous gumming solution comprising a polymer or copolymer on the basis of polyacrylamide.

DE 2530502 discloses a process where developing and gumming is carried out in one single step. This process is, however, only applicable to plates having an interlayer on the substrate.

In WO 2006/026230 and WO 2006/021447 specific hydrophilic polymers are used for post-sealing substrates in a gumming step. The polymer used WO 2006/026230 is obtained by copolymerization of polyethylene glycole methacrylate, acrylic acid and acrylamide while the polymer used in WO 2006/021447 is a phosphono-substituted siloxane.

Treatment of lithographic printing plates with monomeric organo-phosphonic acid chelating compounds is disclosed in US 5736256.

Polyethylene imine derivatives and polyvinylamine derivatives are described as useful components for fountain solutions in WO 2006/056439. Fountain solutions containing said derivatives are said to be able to provide a stable water film even with a reduced amount of isopropanol in the fountain solution. The use of such derivatives in finishers is not disclosed.

EP 490 231 discloses polyethylene imine and polyvinyl amine derivatives as interlayer material for lithographic printing plates. The use of such derivatives in finisher solutions is not disclosed and is also not obvious to a skilled person as a skilled person for instance knows that polyvinylphosphonic acid (PVPA) commonly known as interlayer material is not suitable for finishers.

In WO 2007/057442 a method of making a lithographic printing plate is disclosed wherein the photopolymerizable layer comprises a polymer containing an acid group and a basic nitrogen-containing compound capable of neutralizing said acid group.

In WO 2007/057333, WO 2007/057334, WO 2007/057335, WO 2007/057336, WO 2007/057347, WO 2007/057348, WO 2007/057349, and WO 2007/057410 methods for making lithographic printing plates are disclosed. The use of a polyethylene imine in the overcoat of a lithographic printing plate precursor is disclosed there but not the use of polyethylene imine derivatives in finisher solutions.

It is the object of the present invention to provide a process for the production of a lithographic printing plate and for the posttreatment ("finishing", "gumming") of a (developed) lithographic printing plate thereby allowing the use of substrates without interlayer which improves adhesion of the image areas to the substrate (resulting in a higher sensitivity) and allowing baking of the imaged plates if necessary, without interfering with the delicate equilibrium between printing ink and water and without causing problems such as bad roll-up behaviour and toning upon re-starting the printing machine.

This object is achieved by a process wherein after image-wise exposure and developing a finisher solution comprising 0.01 to 15 wt.%, based on the total weight of the finisher, of a hydrophilic polymer comprising:

(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50,

is applied to an imaged printing plate.

The object is also achieved by an alternative process wherein the oleophilic image areas are image-wise applied onto a lithographic substrate and subsequently the above-described finisher solution is applied.

As used in the present invention, the term "printing plate precursor" refers to an unimaged plate (i.e. a plate that has not been image-wise exposed and developed), from which a printing plate is produced by image-wise exposure and developing. As used in the present invention, the term "printing plate" refers to an imaged plate (also referred to as "printing form") produced from a printing plate precursor.

The process of the present invention can be used for finishing imaged printing plates derived from positive working precursors as well as negative working precursors, each of them can be sensitive to UV, Vis or IR radiation.

Any embodiment, preferred range etc. described below can be combined with one or more other embodiments, preferred ranges etc. described below. All such possible combinations are within the scope of the present disclosure even if they are not explicitly mentioned.

*PRECURSORS*

The printing plate precursors used in the present invention can be a negative working precursor as well as a positive working precursor; the precursors can be sensitive to UV/Vis radiation or IR radiation. Any type of precursor, especially the examples of suitable precursors described in the following, can be combined with any embodiment of the present invention (e.g. any embodiment with respect to the hydrophilic polymer in the finisher solution) described below.

*Substrates*

The substrate used for the precursors is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition.

Among these substrates, an aluminum plate or foil is especially preferred since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates are metal substrates, wherein the term "metal substrate" as used herein also encompasses composite films with the upper-most layer being a metal layer or foil.

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or $HNO_3$, and optionally anodizing, e.g. in sulfuric acid or phosphoric acid. According to a preferred embodiment the metal substrate comprises an $Al_2O_3$-, ZnO-, $SiO_2$- or $TiO_2$-layer.

With the process of the present invention it is also possible to prepare lithographic printing plates which do not show toning although the oxide layer has defects.

An aluminum foil which preferably has a thickness of 0.1 to 0.7 mm, more preferred 0.15 to 0.5 mm, is an especially preferred substrate. It is preferred that the foil be grained (preferably electrochemically) and then show an average roughness of 0.2 to 1 $\mu$m, especially preferred 0.3 to 0.8 $\mu$m.

According to an especially preferred embodiment, the grained aluminum foil was furthermore anodized. The layer weight of the resulting aluminum oxide is preferably 1.5 to 5 $g/m^2$, especially preferred 2 to 4 $g/m^2$.

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface. According to one embodiment of the present invention, the substrate does not comprise an interlayer. It is an advantage of the present invention that substrates without interlayer do not suffer from a toning problem on press if the imaged plate is finished according to the process of the present invention.

The details of the above-mentioned substrate treatments are well known to the person skilled in the art.

*<u>Negative working radiation-sensitive elements</u>*

Negative working coatings are described in numerous references, e.g. UV-sensitive coatings on the basis of negative diazo resins are described in EP 0 752 430 B1, photopolymer layers sensitive to 405 nm are described in DE 103 07 451, photopolymer layers sensitive to VIS are described in EP 0 684 522 B1 and IR-sensitive polymerizable systems are described in DE 199 06 823 A1.

*PHOTOPOLYMERIZATION (UV/VIS AND IR)*

One type of negative working coating applied onto a substrate comprises (a) at least one absorber component selected from photoinitiators and sensitizer/coinitiator systems which absorbs radiation of a wavelength in the range of 250 to 1,200 nm and is capable of initiating a free-radical polymerization, (b) a free-radical polymerizable monomer, oligomer and/or prepolymer, and optionally (c) at least one polymeric binder.

*Absorber component*

The radiation-sensitive coating furthermore comprises at least one absorber component selected from photoinitiators and sensitizer/coinitiator systems.

The absorber component is selected such that it is capable of significant absorption in the range in which the radiation source to be used later on during imaging emits; preferably, the absorber shows an absorption maximum in that range. Thus, if the radiation-sensitive element is e.g. going to be imaged by means of an IR laser, the absorber should essentially absorb radiation in the range of about 750 to 1,200 nm and preferably show an absorption maximum in that range. On the other hand, if imaging is to be carried out by means of UV/VIS radiation, the absorber should essentially absorb radiation in the range of about 250 to 750 nm and preferably show an absorption maximum in that range. Suitable photoinitiators and/or sensitizers are known to the person skilled in the art, or it can easily be determined whether significant absorption occurs in the desired wave length range by means of simple tests (e.g. recording an absorption spectrum).

In the present invention, a photoinitiator is a compound capable of absorbing radiation when exposed and of forming free radicals by itself, i.e. without the addition of coinitiators. Examples of suitable photoinitiators absorbing UV or VIS radiation include triazine derivatives with 1 to 3 $CX_3$ groups (wherein every X is independently selected from a chlorine or bromine atom, and is preferably a chlorine atom), hexaarylbisimidazole compounds, benzoin ethers, benzil ketals, oxime ethers, oxime esters, $\alpha$-hydroxy- or $\alpha$-amino-acetophenones, acylphosphines, acylphosphine oxides, acylphosphine sulfides, metallocenes, peroxides etc. Examples of suitable triazine derivatives include 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloremethyl)-s-triazine, and 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine. Suitable oxime ethers and oxime esters are for example those derived from benzoin. Preferred metallocenes are for example titanocenes with two five-membered cyclodienyl groups such as e.g. cyclopentadienyl groups and one or two six-membered aromatic groups having at least one ortho-fluorine atom and optionally also one pyrryl group; most preferred metallocenes are bis(cyclopentadienyl)-bis-[2,6-difluoro-3-(pyrr-1-yl)-phenyl]titanium and dicyclopentadiene-bis-2,4,6-trifluorophenyl-titanium or zirconium.

In the present invention, a single photoinitiator or a mixture of two or more can be used.

The photoinitiators can be used alone or in combination with one or more coinitiators; the addition of coinitiators can increase the effectiveness of the photoinitiation.

The amount of photoinitiator(s) is not particularly restricted; however, if photoinitiators are present, it is preferably in the range of 0.2 to 25 wt-%, based on the dry layer weight, especially preferred 0.5 to 15 wt-%.

A sensitizer as referred to in the present invention is a compound which can absorb radiation when it is exposed but which *cannot* by itself, i.e. without the addition of coinitiators, form free radicals.

All light-absorbing compounds that are photooxidizable or photoreducible or capable of transferring their excitation energy to receptor molecules are suitable sensitizers for use in the present invention. Examples of such dyes include cyanine dyes, merocyanine dyes, oxonol dyes, diarylmethane dyes, triarylmethane dyes, xanthene dyes, coumarin derivatives, ketocoumarin dyes, acridine dyes, phenazine dyes, quinoxaline dyes, pyrrylium dyes or thiapyrrylium dyes, azaanulene dyes (such as phthalocyanines and porphyrines), indigo dyes, anthraquinone dyes, polyarylenes, polyarylpolyenes, 2,5-diphenylisobenzofuranes, 2,5-diarylfuranes, 2,5-diarylthiofuranes, 2,5-diarylpyrroles, 2,5-diarylcyclopentadienes, poly-arylphenylenes, polyaryl-2-pyrazolines, carbonyl compounds such as aromatic ketones or quinones, e.g. benzophenone derivatives, Michler's ketone, thioxanthone derivatives, anthraquinone derivatives and fluorenone derivatives.

Coumarin sensitizers of formula (I) are for example suitable for the UV range of the electromagnetic spectrum:

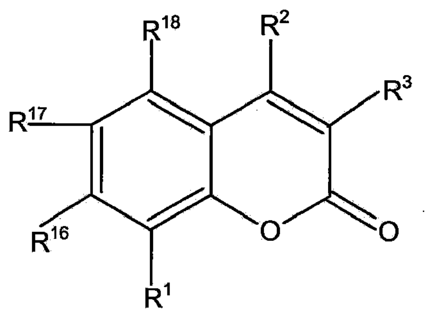

(I)

wherein

$R^1$, $R^{16}$, $R^{17}$ and $R^{18}$ are independently selected from -H, a halogen atom, $C_1$-$C_{20}$ alkyl, -OH, -O-$R^4$ and -$NR^5R^6$, wherein $R^4$ is $C_1$-$C_{20}$ alkyl, $C_5$-$C_{10}$ aryl or $C_6$-$C_{30}$ aralkyl (preferably $C_1$-$C_6$ alkyl) and $R^5$ and $R^6$ are independently selected from a hydrogen atom and $C_1$-$C_{20}$ alkyl,

or $R^1$ and $R^{16}$, $R^{16}$ and $R^{17}$ or $R^{17}$ and $R^{18}$ together form a 5- or 6-membered heterocyclic ring with a heteroatom, selected from N and O, in one or both positions adjacent to the phenyl ring shown in formula (I),

or $R^{16}$ or $R^{17}$ forms, together with its two adjacent substituents, a 5- or 6-membered heterocyclic ring with a heteroatom, selected from N and O, in one or both positions adjacent to the phenyl ring shown in formula (I),

wherein each formed 5- or 6-membered heterocyclic ring can independently be substituted with one or more $C_1$-$C_6$ alkyl groups,

with the proviso that at least one of $R^1$, $R^{16}$, $R^{17}$ and $R^{18}$ is different from hydrogen and $C_1$-$C_{20}$ alkyl,

$R^2$ is a hydrogen atom, $C_1$-$C_{20}$ alkyl, $C_5$-$C_{10}$ aryl or $C_6$-$C_{30}$ aralkyl and

$R^3$ is a hydrogen atom or a substituent selected from -COOH, -$COOR^7$, -$COR^8$, -$CONR^9R^{10}$, -CN, $C_5$-$C_{10}$ aryl, $C_6$-$C_{30}$ aralkyl, a 5- or 6-membered heterocyclic optionally benzofused group, a group -CH=CH-$R^{12}$ and

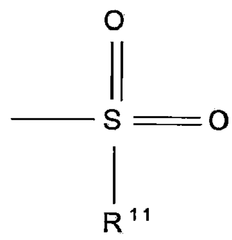

wherein $R^7$ is $C_1$-$C_{20}$ alkyl, $R^8$ is $C_1$-$C_{20}$ alkyl or a 5- or 6-membered heterocyclic group, $R^9$ and $R^{10}$ are independently selected from a hydrogen atom and $C_1$-$C_{20}$ alkyl, $R^{11}$ is $C_1$-$C_{12}$ alkyl or alkenyl, a heterocyclic non-aromatic ring or $C_5$-$C_{20}$ aryl optionally with a heteroatom, selected from O, S and N, and $R^{12}$ is $C_5$-$C_{10}$ aryl or a 5- or 6-membered heterocyclic, optionally aromatic, ring;
or $R^2$ and $R^3$, together with the carbon atoms to which they are bonded, form a 5- or 6-membered, optionally aromatic, ring.

They are described in more detail e.g. in WO 2004/049068 A1.

Furthermore, bisoxazole derivatives and analogues of the formula (II) are suitable for the UV range

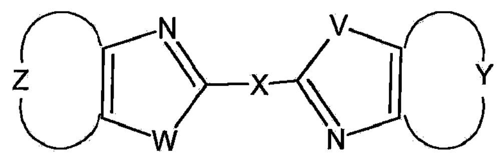

(II)

wherein X is a spacer group comprising at least one C-C double bond conjugated to the heterocycles,
Y and Z independently represent an optionally substituted fused aromatic ring and
V and W are independently selected from O, S and NR, wherein R is an alkyl, aryl or aralkyl group which can optionally be mono- or polysubstituted, as described in more detail in WO 2004/074929 A2, and oxazole compounds of the formula (III)

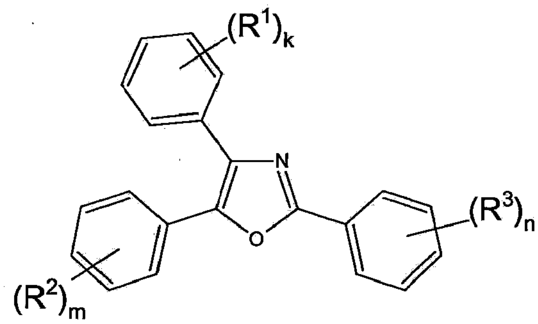

(III)

wherein each $R^1$, $R^2$ and $R^3$ is independently selected from a halogen atom, an optionally substituted alkyl group, an optionally substituted aryl group, which may also be fused, an optionally substituted aralkyl group, a group $-NR^4R^5$ and a group $-OR^6$,
wherein $R^4$ and $R^5$ are independently selected from a hydrogen atom, an alkyl, aryl or aralkyl group,
$R^6$ is an optionally substituted alkyl, aryl or aralkyl group or a hydrogen atom, and k, m and n are independently 0 or an integer from 1 to 5, as described in detail in WO 2004/074930 A2.

The 1,4-dihydropyridine compounds of formula (IV) as described in WO 2004/111731 A1 are an example of another class of sensitizers suitable for the UV range

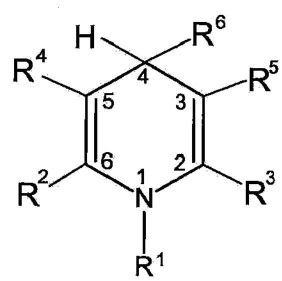

(IV)

wherein
$R^1$ is selected from a hydrogen atom, -C(O)$OR^7$, an optionally substituted alkyl group, an optionally substituted aryl group and an optionally substituted aralkyl group,
$R^2$ and $R^3$ are independently selected from optionally substituted alkyl groups, optionally substituted aryl groups, CN and a hydrogen atom,
$R^4$ and $R^5$ are independently selected from -C(O)$OR^7$, -C(O)$R^7$, -C(O)$NR^8R^9$ and CN,
or $R^2$ and $R^4$ together form an optionally substituted phenyl ring or a 5- to 7-membered carbocyclic or heterocyclic ring, wherein the unit

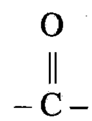

is present in the carbocyclic or heterocyclic ring adjacent to position 5 of the dihydropyridine ring and wherein the carbocyclic or heterocyclic ring optionally comprises additional substituents,
or both $R^2$ and $R^4$ as well as $R^3$ and $R^5$ form either optionally substituted phenyl rings or 5- to 7-membered carbocyclic or heterocyclic rings, wherein the unit

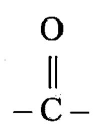

is present in the carbocyclic or heterocyclic rings adjacent to positions 3 and 5 of the dihydropyridine ring and wherein the carbocyclic or heterocyclic rings optionally comprise additional substituents,
or one of the pairs $R^2/R^4$ and $R^3/R^5$ forms a 5- to 7-membered carbocyclic or heterocyclic ring, wherein the unit

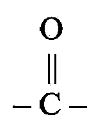

is present in the carbocyclic or heterocyclic ring adjacent to position 5 or 3 of the dihydropyridine ring and wherein the carbocyclic or heterocyclic ring optionally comprises additional substituents and the other pair forms an optionally substituted phenyl ring, or $R^2$ and $R^1$ or $R^3$ and $R^1$ form a 5- to 7-membered heterocyclic ring which can optionally comprise one or more substituents and which, in addition to the nitrogen atom it shares with the 1,4-dihydropyridine ring, optionally comprises additional nitrogen atoms, -$NR^{13}$ groups, -S- or -O-,
$R^{13}$ is selected from a hydrogen atom, an alkyl group, aryl group and aralkyl group,
$R^6$ is selected from an alkyl group optionally substituted with a halogen atom or a -C(O) group, an optionally substituted aryl group, an optionally substituted aralkyl group, an optionally substituted heterocyclic group and the group

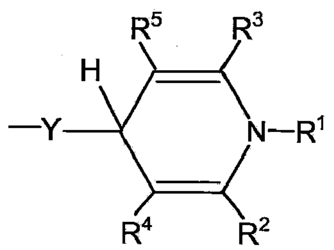

Y is an alkylene or arylene group,

$R^7$ is a hydrogen atom, aryl group, aralkyl group or alkyl group, wherein the alkyl group and the alkyl unit of the aralkyl group optionally comprise one or more C-C double and/or C-C triple bonds,

and $R^8$ and $R^9$ are independently selected from a hydrogen atom, an optionally substituted alkyl group, an optionally substituted aryl group and an optionally substituted aralkyl group.

The sensitizers of formulas (V), (VI), (VII), and (VIII) are also suitable for UV sensitive elements. They are especially suitable for plates imaged by 30 μm (and lower) FM screening (FM = frequency-modulated):

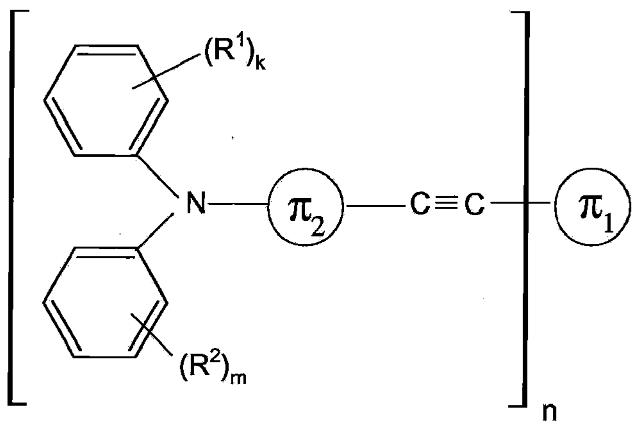

(V)

wherein

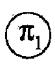 and each 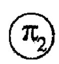 independently represent an aromatic or heteroaromatic unit,

each $R^1$ and $R^2$ is independently selected from a halogen atom, an alkyl, aryl or aralkyl group, a group $-NR^4R^5$ or a group $-OR^6$,

$R^4$, $R^5$ and $R^6$ are independently selected from an alkyl, aryl and aralkyl group and

n is an integer of at least 2 and

k and m independently represent 0 or an integer from 1 to 5;

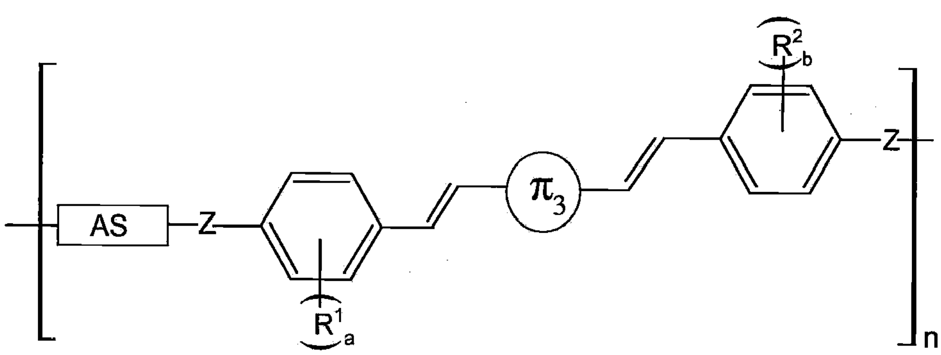

(VI)

wherein 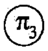 is an aromatic or heteroaromatic unit or a combination of the two so that a conjugated $\pi$-system is present between the two groups Z in structure (I),

each Z independently represents a heteroatom connecting the spacer AS and the conjugated system,

each $R^1$ and $R^2$ is independently selected from a halogen atom, an alkyl, aryl, alkylaryl or aralkyl group, a group $-NR^3R^4$ and a group $-OR^5$,

each $R^3$, $R^4$ and $R^5$ is independently selected from an alkyl, aryl, alkylaryl and aralkyl group, a and b independently represent 0 or an integer from 1 to 4,

n has a value of >1 and

AS is an aliphatic spacer,

(described in more detail in DE 10 2004 055 733);

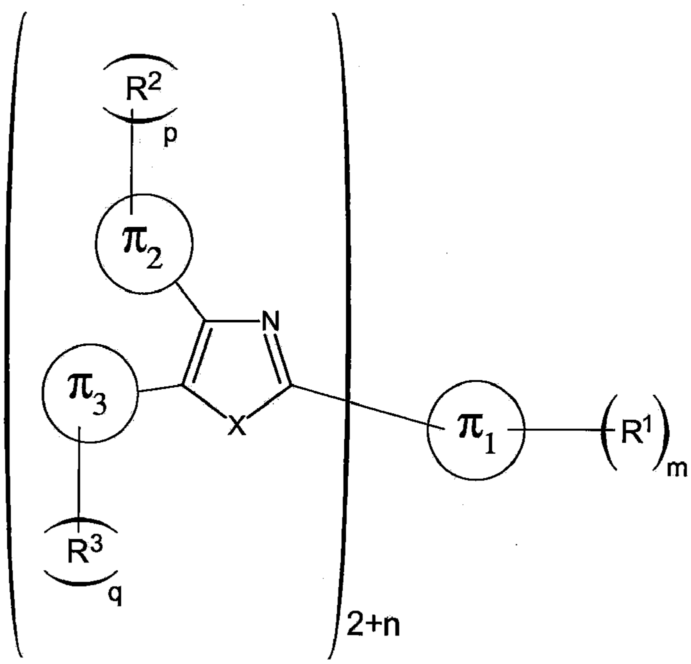

(VII)

wherein

X is selected from O, S and Se;

n represents 0 or a positive integer;

m, p and q are independently 0 or a positive integer;

the $\pi$-units 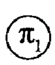 , 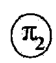 and 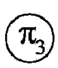 are independently unsaturated units, each with a conjugated $\pi$-electron system, which are covalently bonded to the heterocyclic unit

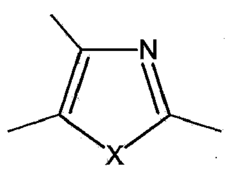

and together with this unit again form a conjugated $\pi$-electron system and

each group $R^1$, $R^2$ and $R^3$ is independently selected from a hydrogen atom, a halogen atom, an alkyl group, an aralkyl group, a group $-NR^4R^5$ and a group $-OR^6$,

wherein $R^4$, $R^5$ and $R^6$ are independently selected from an alkyl group, aryl group and aralkyl group,

(described in more detail in DE 10 2004 022 137 B3);

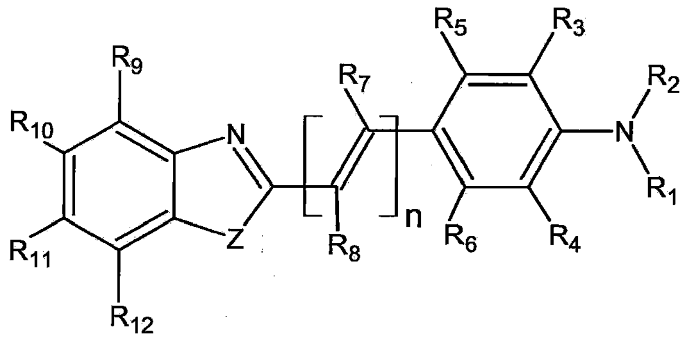

(VIII)

wherein
$R_1$ and $R_2$ are independently selected from the group consisting of hydrogen, unsubstituted and substituted aryl, unsubstituted and substituted heteroaryl and unsubstituted and substituted alkyl, said aryl or heteroaryl group being linked to $R_3$ or $R_4$ to form a 5- or 6-membered N-heteroaryl ring or not being linked to $R_3$ and $R_4$; provided that at least one of the groups $R_1$ and $R_2$ is an unsubstituted or substituted aryl or heteroaryl group;
or $R_1$ and $R_2$ together with the nitrogen atom to which they are attached form an N-heteroaryl group which either exhibits one or two fused benzene rings or does not exhibit any fused benzene rings;
$R_3$ and $R_4$ are independently selected from the group consisting of hydrogen, CN, halogen, unsubstituted and substituted alkyl, aralkyl, alkylaryl and aryl, -O-alkyl, -O-aryl, -S-alkyl, - COOR, -SOR, $-SO_2R$, $-SO_3R$, $-NO_2$, $NR_2$, $NR_3^+$, and $-PO_3R_2$, wherein each R is selected from H, alkyl, aryl, aralkyl and alkylaryl, or $R_3$ or $R_4$ are linked to an aryl or heteroaryl group represented by $R_1$ or $R_2$ to form a 5- or 6-membered N-heteroaryl ring;
$R_5$ and $R_6$ are independently selected from the group consisting of hydrogen, CN, halogen, unsubstituted and substituted alkyl, aralkyl, alkylaryl and aryl, -O-alkyl, -O-aryl, -S-alkyl, - COOR, -SOR, $-SO_2R$, $-SO_3R$, $-NO_2$, $NR_2$, $NR_3^+$, and $-PO_3R_2$, wherein each R is selected from the group consisting of H, alkyl, aryl, aralkyl and alkylaryl, or, if $R_3$ and $R_4$ are not linked to $R_1$ and $R_2$, respectively, $R_5$ and $R_3$ and/or $R_6$ and $R_4$ form a 5- or 6-membered fused aromatic ring;
$R_7$ and $R_8$ are independently selected from the group consisting of hydrogen, CN, halogen, and unsubstituted and substituted alkyl, alkylaryl, aralkyl, and aryl;
n is selected from 0, 1 and 2;
Z represents O, S, Se or NR, wherein R is selected from the group consisting of hydrogen, alkyl, aryl, aralkyl and alkylaryl;
$R_9$ to $R_{12}$ are independently selected from the group consisting of hydrogen, halogen, CN, unsubstituted and substituted alkyl, aralkyl, alkylaryl and aryl, -O-alkyl, -O-aryl, -S-alkyl, - COOR, -SOR, $-SO_2R$, $-SO_3R$, $-NO_2$, $NR_2$, $NR_3^+$, and $-PO_3R_2$, wherein each R is selected from the group consisting of H, alkyl, aryl, aralkyl and alkylaryl, provided that at least one of the groups $R_9$ to $R_{12}$ is a bulky group which has a van der Waals volume of at least 55 $Å^3$.

If the radiation-sensitive elements are to be exposed with VIS laser diodes, the cyanopyridone derivatives described in WO 03/069411 A1 are for example suitable as sensitizers.

For IR-sensitive elements, the sensitizers are for example selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR absorbers. Further examples can be found in US 4,327,169, US 4,756,993, US 5,156,938, WO 00/29214, US 6,410,207 and EP 1 176 007 A1.

According to one embodiment, a cyanine dye of formula (IX)

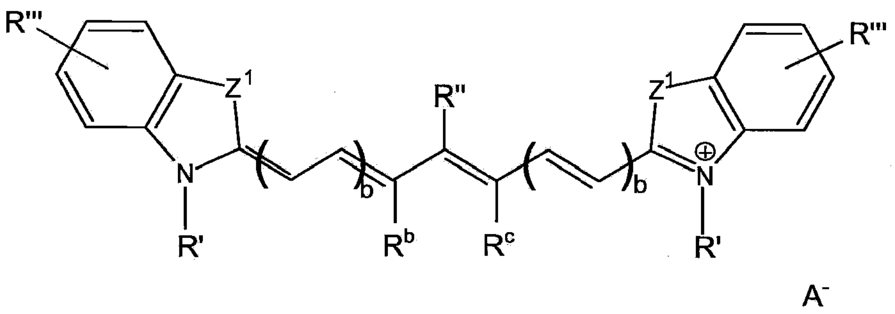

(IX)

is used, wherein
each $Z^1$ independently represents S, O, $NR^a$ or $C(alkyl)_2$;
each R' independently represents an alkyl group, an alkylsulfonate group or an alkylammonium group;
R" represents a halogen atom, $SR^a$, $OR^a$, $SO_2R^a$ or $NR^a_2$;
each R"' independently represents a hydrogen atom, an alkyl group, $-COOR^a$, $-OR^a$, $-SR^a$, $-NR^a_2$ or a halogen atom;
R"' can also be a benzofused ring;
$A^-$ represents an anion;
$R^b$ and $R^c$ either both represent hydrogen atoms or, together with the carbon atoms to which they are bonded, form a carbocyclic five- or six-membered ring;
$R^a$ represents a hydrogen atom, an alkyl or aryl group;
each b is independently 0, 1, 2 or 3.

If R' represents an alkylsulfonate group, an internal salt can form so that no anion $A^-$ is necessary. If R' represents an alkylammonium group, a second counterion is needed which is the same as or different from $A^-$.

Of the IR dyes of formula (IX), dyes with a symmetrical structure are especially preferred. Examples of especially preferred dyes include:

2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,

2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,

2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,

2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium tosylate and

2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR absorbers suitable for the present invention:

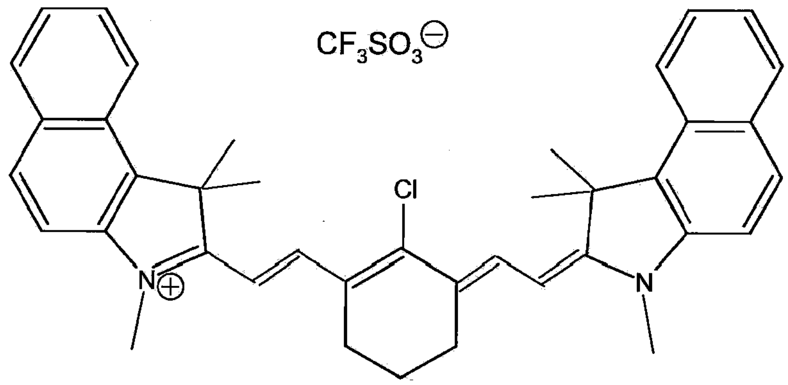

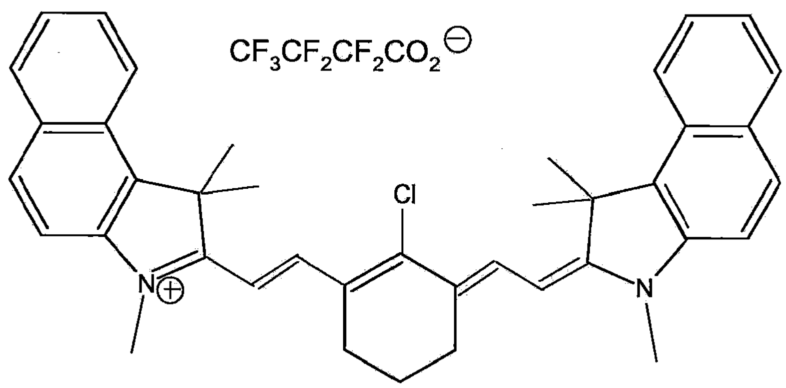

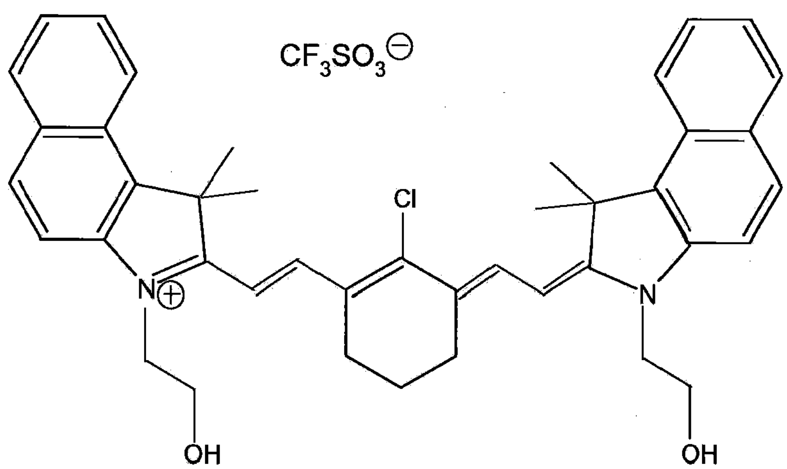

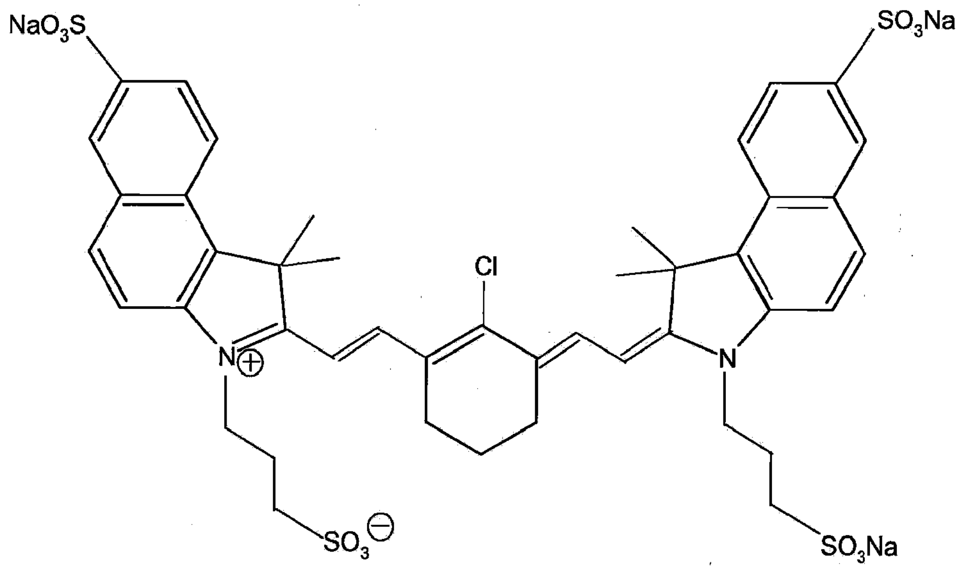

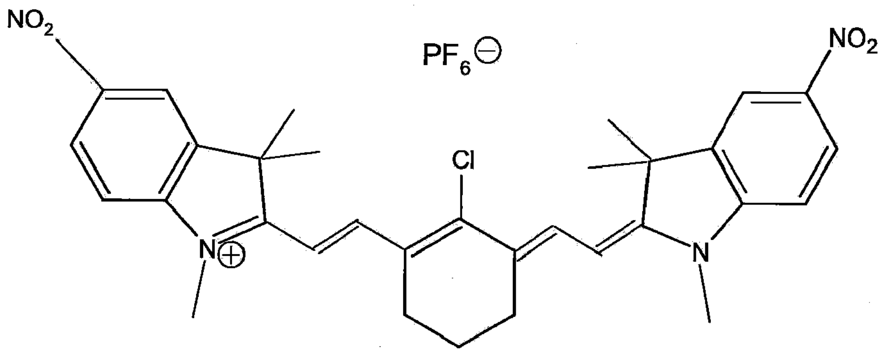

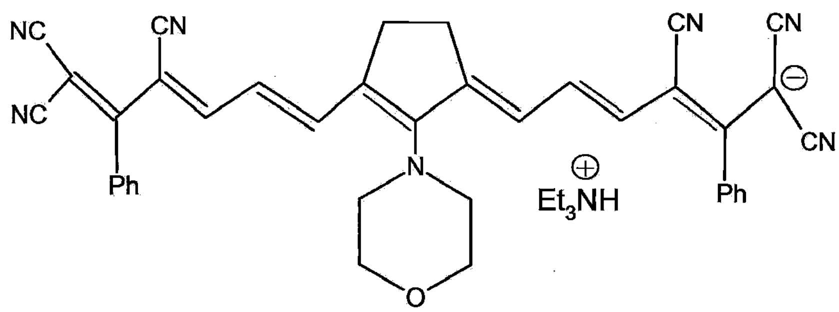

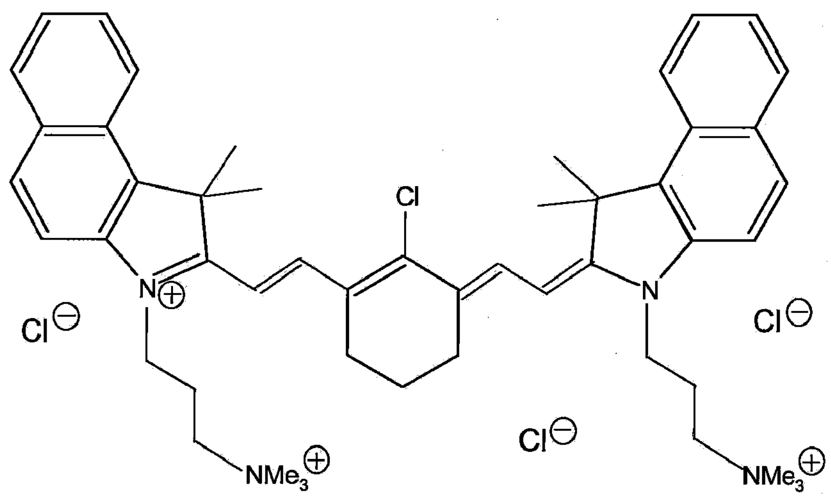

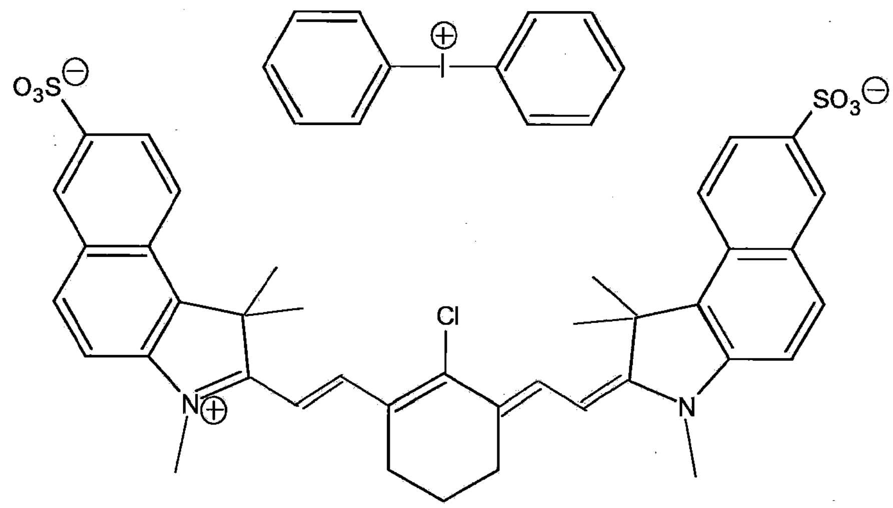

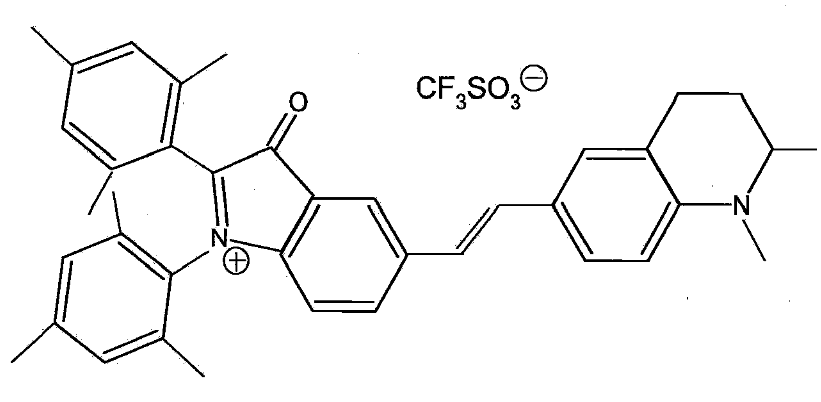

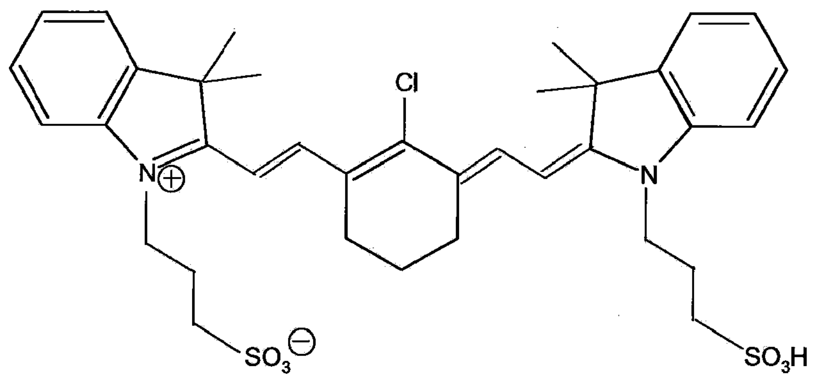

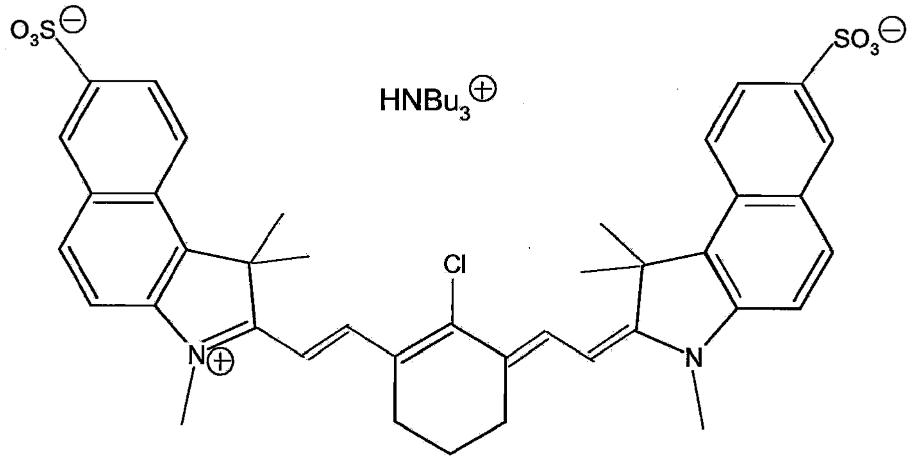

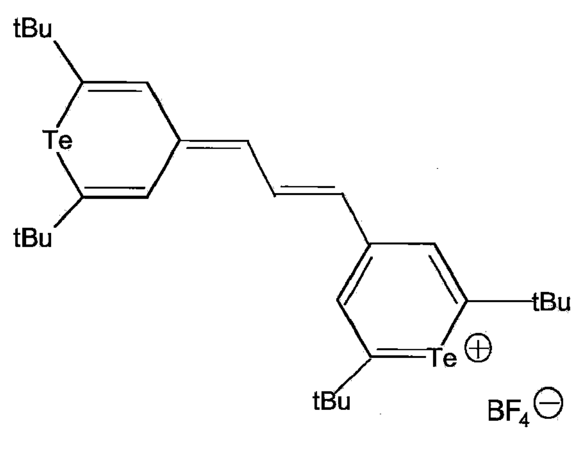

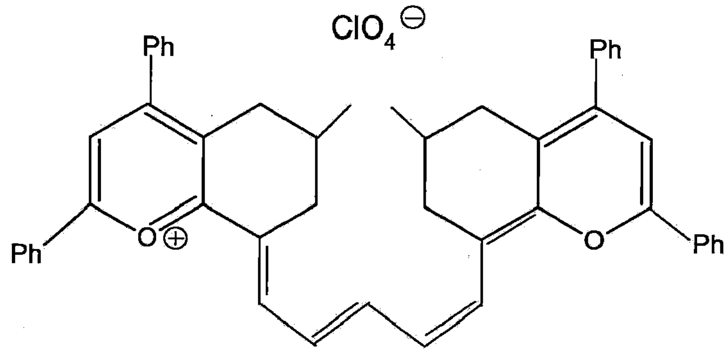

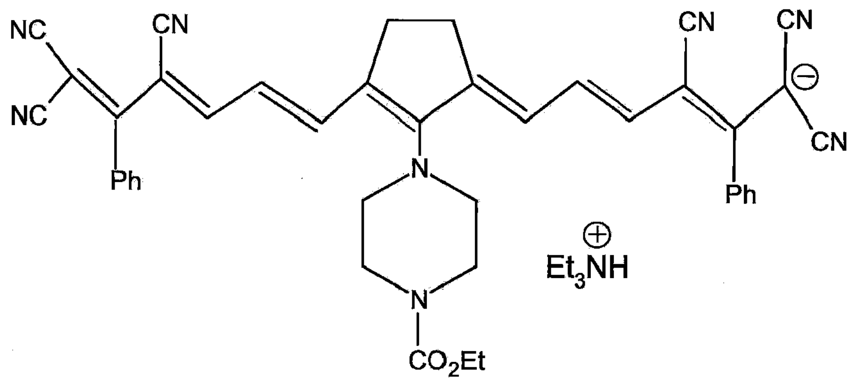

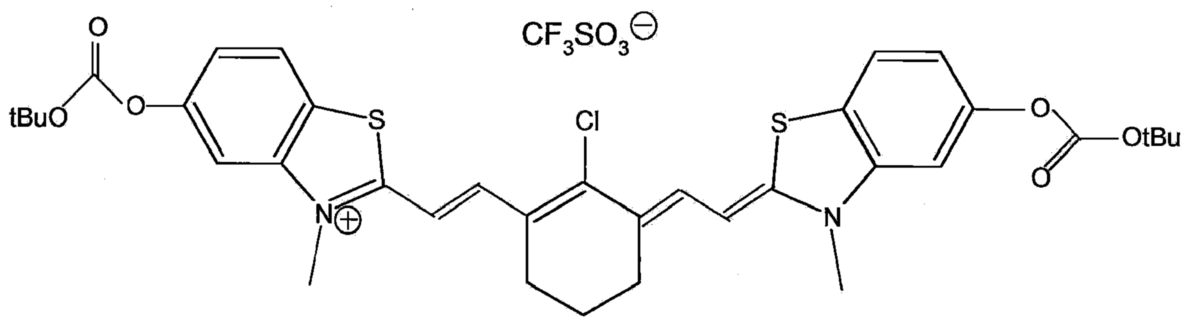

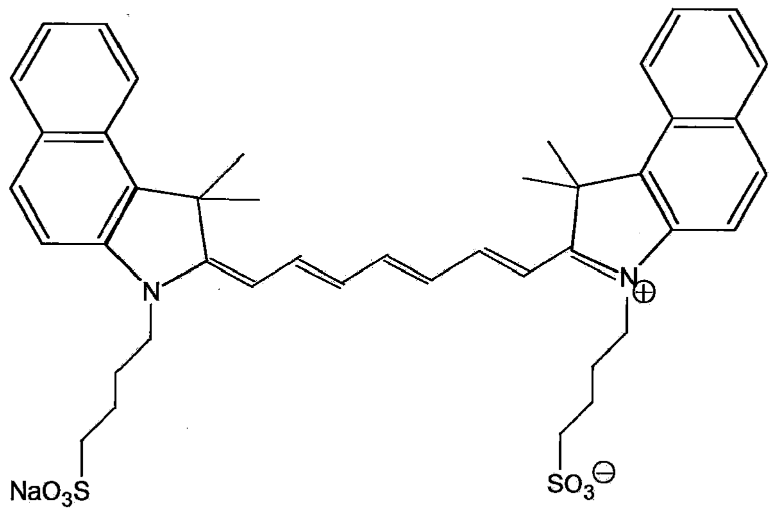

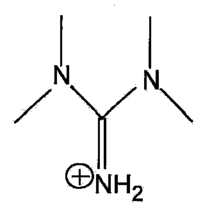

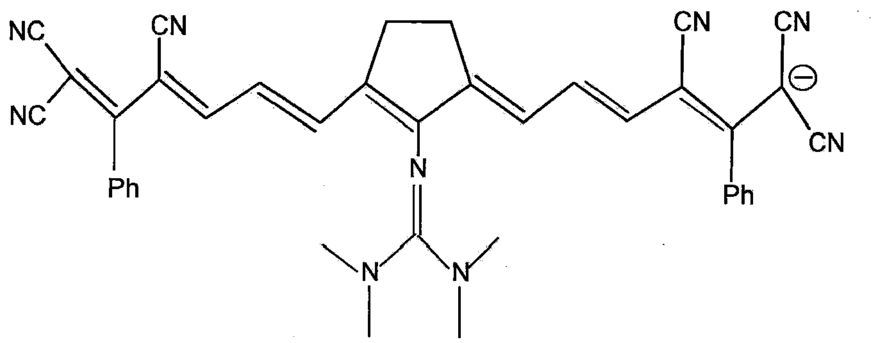

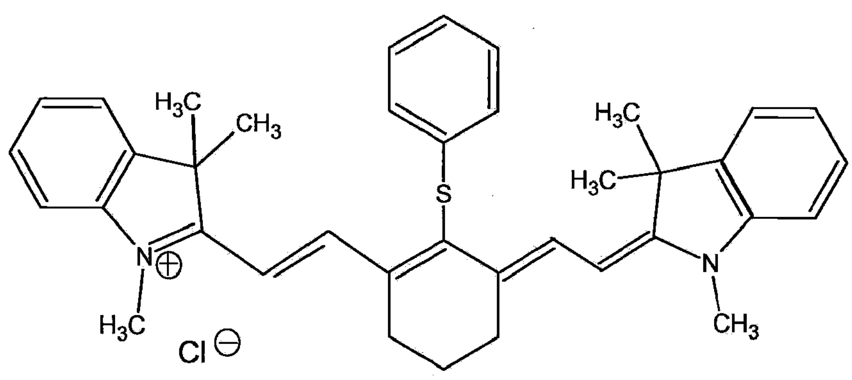

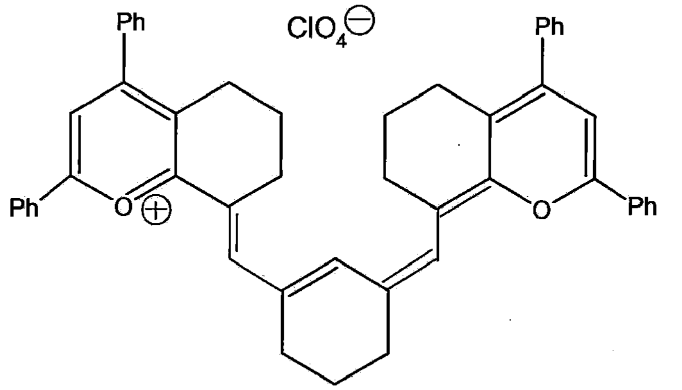

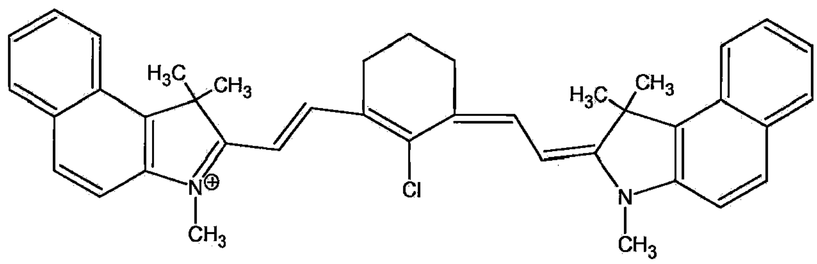

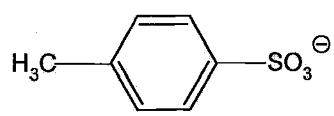

In the present invention, one sensitizer or a mixture of two or more can be used.

The sensitizers are used in combination with one or more coinitiators. Additionally, photoinitiators can be used; however, this is not preferred.

The amount of sensitizer(s) is not particularly restricted; however, if sensitizers are present, it is preferably in the range of 0.2 to 15 wt-%, based on the dry layer weight, especially preferred 0.5 to 10 wt-%. If both photoinitiators and sensitizers are present in the coating, their total amount is preferably 0.5 to 30 wt-%, based on the dry layer weight, especially preferred 1 to 15 wt-%.

A coinitiator as referred to in the present invention is a compound that is essentially unable to absorb when irradiated but forms free radicals together with the radiation-absorbing sensitizers used in the present invention. The coinitiators are for example selected from onium compounds, for example those where the onium cation is selected from iodonium (such as e.g. triaryliodonium salts), sulfonium (such as triarylsulfonium salts), phosphonium, oxylsulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl; N-arylglycines and derivatives thereof (e.g. N-phenylglycine); aromatic sulfonyl halides; trihalomethylarylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles; thiol compounds (e.g. mercaptobenzthiazole, mercaptobenzimidazole and mercaptotriazole); 1,3,5-triazine derivatives with 1 to 3 $CX_3$ groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; metallocenes (preferably titanocenes, and especially preferred those with two five-membered cyclodienyl groups, such as e.g. cyclopentadienyl groups and one

or two six-membered aromatic groups with at least one ortho fluorine atom and optionally also a pyrryl group, such as bis(cyclopentadienyl)-bis-[2,6-difluoro-3-(pyrr-1-yl)-phenyl]titanium and dicyclopentadiene-bis-2,4,6-trifluorophenyl-titanium or zirconium); acylphosphine oxides, diacylphosphine oxides and peroxides (e.g. those listed in EP-A1-1 035 435 as activators of the type of an organic peroxide), α-hydroxy or α-amino acetophenones, acylphosphines, acylphosphinesulfides, carbonyl compounds such as aromatic ketones or quinones, e.g. benzophenone derivatives, Michler's ketone, thioxanthone derivatives, anthraquinone derivatives and fluorenone derivatives.

Suitable 2,2',4,4',5,5'-hexaarylbiimidazoles (in the following simply referred to as hexaarylbiimidazoles) are represented by the following formula (X):

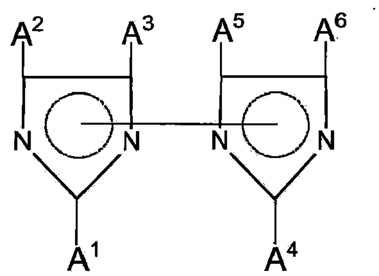

(X)

wherein $A^1$-$A^6$ are substituted or unsubstituted $C_5$-$C_{20}$ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, $C_1$-$C_6$ alkyl (optionally with one or more substituents selected from halogen atoms, -CN and -OH), $C_1$-$C_6$ alkoxy, $C_1$-$C_6$ alkylthio, ($C_1$-$C_6$ alkyl) sulfonyl.

Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

Examples include:

2,2'-Bis(bromophenyl)-4,4',5,5'-tetraphenylbiimidazole,
2,2'-bis(p-carboxyphenyl)-4,4',5,5'-tetraphenylbiimidazole,
2,2'-bis(o-chlorophenyl)-4,4',5,5'-tetrakis(p-methoxyphenyl)biimidazole,
2,2'-bis(p-chlorophenyl)-4,4',5,5'-tetrakis(p-methoxyphenyl)biimidazole,
2,2'-bis(p-cyanophenyl)-4,4'5,5'-tetrakis(p-methoxyphenyl)biimidazole,
2,2'-bis(2,4-dichlorophenyl)-4,4',5,5'-tetraphenylbiimidazole,
2,2'-bis(2,4-dimethoxyphenyl)-4,4',5,5'-tetraphenylbiimidazole,
2,2'-bis(o-ethoxyphenyl)-4,4',5;5'-tetraphenylbiimidazole,
2,2'-bis(m-fluorophenyl)-4,4',5,5'-tetraphenylbiimidazole,
2,2'-bis(o-fluorophenyl)-4,4',5,5'-tetraphenylbiimidazole,
2,2'-bis(p-fluorophenyl)-4,4',5,5'-tetraphenylbiimidazole,
2,2'-bis(o-hexoxyphenyl)-4,4',5,5'-tetraphenylbiimidazole,
2,2'-bis(o-hexylphenyl)-4,4',5,5'-tetrakis(p-methoxyphenyl)biimidazoie,
2,2'-bis(3,4-methylenedioxyphenyl)-4,4',5,5'-tetraphenylbiimidazole,
2,2'-bis(o-chlorophenyl)-4,4',5,5'-tetrakis(m-methoxyphenyl)biimidazole,
2,2'-bis(o-chlorophenyl)-4,4',5,5'-tetrakis[m-(betaphenoxy-ethoxyphenyl)]biimidazole,
2,2'-bis(2,6-dichlorophenyl)-4,4',5,5'-tetraphenylbiimidazole,
2,2'-bis(o-methoxyphenyl)-4,4',5,5'-tetraphenylbiimidazole,
2,2'-bis(p-methoxyphenyl)-4,4'-bis(o-methoxyphenyl)-5,5'-diphenylbiimidazole,
2,2'-bis(o-nitrophenyl)-4,4',5,5'-tetraphenylbiimidazole,
2,2'-bis(p-phenylsulfonylphenyl)-4,4',5,5'-tetraphenylbiimidazole,
2,2'-bis(p-sulfamoylphenyl)-4,4',5,5'-tetraphenylbiimidazole,
2,2'-bis(2,4,5-trimethylphenyl)-4,4',5,5'-tetraphenylbiimidazole,
2,2'-di-4-biphenylyl-4,4',5,5'-tetraphenylbiimidazole,
2,2'-di-1-naphthyl-4,4',5,5'-tetrakis(p-methoxyphenyl)biimidazole,
2,2'-di-9-phenanthryl-4,4',5,5'-tetrakis(p-methoxyphenyl)biimidazole,

2,2'-diphenyl-4,4',5,5'-tetra-4-biphenylylbiimidazole,
2,2'-diphenyl-4,4',5,5'-tetra-2,4-xylylbiimidazole,
2,2'-di-3-pyridyl-4,4',5,5'-tetraphenylbiimidazole,
2,2'-di-3-thienyl-4,4',5,5'-tetraphenylbiimidazole,
2,2'-di-o-tolyl-4,4',5,5'-tetraphenylbiimidazole,
2,2'-di-p-tolyl-4,4'-di-o-tolyl-5,5'-diphenylbiimidazole,
2,2'-di-2,4-xylyl-4,4',5,5'-tetraphenylbiimidazole,
2,2',4,4',5,5'-hexakis(p-benylthiophenyl)biimidazole,
2,2',4,4',5,5'-hexa-1-naphthylbiimidazole,
2,2',4,4',5,5'-hexaphenylbiimidazole,
2,2'-bis(2-nitro-5-methoxyphenyl)-4,4',5,5'-tetraphenylbiimidazole,
2,2'-bis(o-nitrophenyl)-4,4',5,5'-tetrakis(m-methoxyphenyl)biimidazole, and
2,2'-bis(2-chloro-5-sulfophenyl)-4,4',5,5'-tetraphenylbiimidazole,

and especially preferred:

2,2'-bis(o-chlorophenyl)-4,4',5,5'-tetraphenylbiimidazole,
2,2'-bis(o-chlorophenyl)-4,4',5,5'-tetra(p-fluorophenyl)biimidazole,
2,2'-bis(o-bromophenyl)-4,4',5,5'-tetra(p-iodophenyl)biimidazole,
2,2'-bis(o-chlorophenyl)-4,4',5,5'-tetra(p-chloronaphthyl)biimidazole,
2,2'-bis(o-chlorophenyl)-4,4',5,5'-tetra(p-chlorophenyl)biimidazole,
2,2'-bis(o-bromophenyl)-4,4',5,5'-tetra(p-chloro-p-methoxyphenyl)biimidazole,
2,2'-bis(o-chlorophenyl)-4,4',5,5'-tetra(o,p-dichlorophenyl)biimidazole,
2,2'-bis(o-chlorophenyl)-4,4',5,5'-tetra(o,p-dibromophenyl)biimidazole,
2,2'-bis(o-bromophenyl)-4,4',5,5'-tetra(o,p-dichlorophenyl)biimidazole or
2,2'-bis(o,p-dichlorophenyl)-4,4',5,5',-tetra(o,p-dichlorophenyl)biimidazole;

but the invention is not restricted to these compounds.

Suitable hexaarylbiimidazoles can be prepared according to known methods (see e.g. US-A-3,445,232). A preferred process is the oxidative dimerization of corresponding triarylimidazoles with iron-(III)-hexacyanoferrate (II) in an alkali solution.

It is irrelevant for the purposes of the present invention which hexaarylbiimidazole isomer (or mixture of isomers) is used (e.g. 1,2'-, 1,1'-, 1,4', 2,2'-, 2,4'- and 4,4'-isomer), as long as it is photodissociable and provides triarylimidazolyl free radicals in the process.

The trihalogenmethyl compounds suitable as coinitiators are capable of forming free radicals. Trihalogenmethyl-substituted triazines and trihalogenmethyl-arylsulfones are preferred. The following can be mentioned as examples (without restricting the invention to these compounds):

2-(4-Methoxyphenyl)-4,6-bis(trichloromethyl)-s-triazine,
2-(4-chlorophenyl)-4,6-bis-(trichloromethyl)-s-triazine,
2-phenyl-4,6-bis(trichloromethyl)-s-triazine,
2,4,6-tris-(trichloromethyl)-s-triazine,
2,4,6-tris-(tribromomethyl)-s-triazine and
tribromomethylphenylsulfone.

Many coinitiators can also function as photoinitiators when they are exposed in their absorption band. This way, photosensitive layers can be obtained that are e.g. sensitive over a wide spectral range because a photoinitiator or sensitizer covers the long-wavelength spectral range (IR and/or visible range) and a coinitiator covers the short-wavelength spectral range (e.g. the UV range). This effect can be advantageous if the consumer wants to irradiate the same material with different radiation sources. In this case, the coinitiator functions as an actual coinitiator in the sense of the definition given above for the IR or visible range, while it functions as a photoinitiator for the UV range.

In the present invention, one coinitiator or a mixture of coinitiators can be used.

The amount of coinitiator(s) is not particularly restricted; however, it is preferably in the range of 0.2 to 25 wt-%, based on the dry layer weight, especially preferred 0.5 to 15 wt-%.

Further examples of suitable sensitizers and coinitiators for IR-sensitive coatings are also mentioned in WO 2004/041544, WO 2000/48836 and DE 10 2004 003143.

*Free-radical polymerizable component*

All monomers, oligomers and polymers which comprise at least one C-C double bond can be used as free-radical polymerizable monomers, oligomers and polymers. Monomers/oligomers/polymers with C-C triple bonds can also be used, but they are not preferred. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins.

In addition to monomers and/or oligomers, use can also be made of polymers comprising free-radical polymerizable C-C double bonds in the main or side chains. Examples thereof include reaction products of maleic acid anhydride copolymers and hydroxyalkyl(meth)acrylates (cf. e.g. DE 4 311 738 C1); (meth)acrylic acid polymers, partially or fully esterified with allyl alcohol (cf. e.g. DE 3 332 640 A1); reaction products of polymeric polyalcohols and isocyanatoalkyl (meth)acrylates; unsaturated polyesters; (meth)acrylate-terminated polystyrenes, poly(meth)acrylic acid ester, poly (meth)acrylic acids, poly(meth)acrylamides; (meth)acrylic acid polymers, partially or fully esterified with epoxides comprising free-radical polymerizable groups; and polymers with allyl side-groups which can for example be obtained by polymerization of allyl(meth)acrylate, optionally with further comonomers.

Free-radical polymerizable compounds that can be used in the present invention also include compounds that have a molecular weight of 3,000 or less and are reaction products obtained by reacting a diisocyanate with (i) an ethylenically unsaturated compound with one hydroxy group, and at the same time (ii) a saturated organic compound with one NH group and one OH group, wherein the reactants are used in amounts according to the following condition: Number of moles of isocyanate groups ≤ number of moles of OH plus NH groups.

Examples of diisocyanates are represented by the following formula:

$$O{=}C{=}N\text{-}(CR^9_2)_a\text{-}D\text{-}(CR^9_2)_6\text{-}N{=}C{=}O \qquad (XI)$$

wherein a and b independently represent 0 or an integer from 1 to 3, each $R^9$ is independently selected from H and $C_1$-$C_3$ alkyl and D is a saturated or unsaturated spacer which can optionally comprise further substituents in addition to the two isocyanate groups. D can be a chain-shaped or a ring-shaped unit. As used in the present invention, the term "diisocyanate" refers to an organic compound comprising two isocyanate groups but no OH groups and no secondary and primary amino groups.

D can for example be an alkylene group $(CH_2)_w$, wherein w is an integer from 1 to 12, preferably 1 to 6, and one or more hydrogen atoms are optionally replaced with substituents such as e.g. alkyl groups (preferably $C_1$-$C_6$), a cycloalkylene group, an arylene group or a saturated or unsaturated heterocyclic group.

The ethylenically unsaturated compound (i), which comprises a hydroxy group, comprises at least one non-aromatic C-C double bond, which is preferably terminal. The hydroxy group is preferably not bonded to a doubly bonded carbon atom; the hydroxy group is not part of a carboxy group. In addition to the one OH group, the ethylenically unsaturated compound (i) does not comprise any further functional groups, such as e.g. NH, which can react with the isocyanate.

Examples of the ethylenically unsaturated compound (i) include

Hydroxy($C_1$-$C_{12}$)alkyl(meth)acrylates (e.g. 2-hydroxyethyl(meth)acrylate, 2- or 3-hydroxypropyl(meth)acrylate, 2-, 3- or 4-hydroxybutyl(meth)acrylate), hydroxy($C_1$-$C_{12}$)alkyl-(meth)acrylamides (e.g. 2-hydroxyethyl(meth)acrylamide, 2- or 3-hydroxypropyl(meth)-acrylamide, 2-, 3- or 4-hydroxybutyl(meth)acrylamide), mono(meth)acrylates of oligomeric or polymeric ethylene glycols or propylene glycols (e.g. polyethylene glycol mono(meth)acrylate, triethylene glycol mono (meth)acrylate), allyl alcohol, pentaerythritol tri(meth)acrylate, 4-hydroxy($C_1$-$C_{12}$)alkylstyrene (e.g. 4-hydroxymethylstyrene), 4-hydroxystyrene, hydroxycyclohexyl(meth)acrylate.

The term "(meth)acrylate" as used in the present invention indicates that both methacrylate and acrylate etc. are meant.

The saturated organic compound (ii) is a compound with one OH and one NH group.

The saturated organic compound (ii) can for example be represented by the following formula (XII) or (XIII)

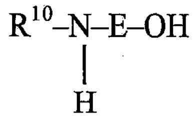

(XII)

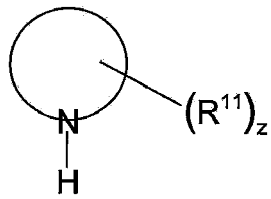

(XIII)

wherein $R^{10}$ is a straight-chain (preferably $C_1$-$C_{12}$, especially preferred $C_1$-$C_4$), branched (preferably $C_3$-$C_{12}$, especially preferred $C_3$-$C_6$) or cyclic (preferably $C_3$-$C_8$, especially preferred $C_5$-$C_6$) alkyl group,
E is a straight-chain (preferably $C_1$-$C_6$, especially preferred $C_1$-$C_2$), branched (preferably $C_3$-$C_{12}$, especially preferred $C_3$-$C_6$) or cyclic (preferably $C_3$-$C_8$, especially preferred $C_5$-$C_6$) alkylene group,

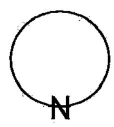

represents a saturated heterocyclic ring with 5 to 7 ring atoms, which in addition to the nitrogen atom shown above optionally comprises another heteroatom selected from S, O and $NR^{12}$, wherein $R^{12}$ is an alkyl group optionally substituted with an OH group,
$R^{11}$ is OH or a straight-chain, branched or cyclic alkyl group substituted with an OH group, and z = 0 if the heterocyclic ring comprises $NR^{12}$ and $R^{12}$ is an alkyl group substituted with OH and z = 1 if the saturated heterocyclic ring does not comprise $NR^{12}$ or if the saturated heterocyclic ring comprises $NR^{12}$ and $R^{12}$ is an unsubstituted alkyl group.

The number of moles of isocyanate groups must not exceed the number of moles of OH groups and NH groups combined since the product should not comprise any more free isocyanate groups.

Additional suitable C-C unsaturated free-radical polymerizable compounds are described e.g. in EP 1 176 007 A2.

It is of course possible to use different kinds of monomers, oligomers or polymers in the mixture; furthermore, mixtures of monomers and oligomers and/or polymers can be used in the present invention, as well as mixtures of oligomers and polymers.

The free-radical polymerizable component is preferably used in an amount of 5 to 95 wt-%, based on the dry layer weight, especially preferred 10 to 85 wt-%.

*Binders*

Suitable binders are polymers/copolymers soluble or dispersible in aqueous alkaline developer, such as e.g. phenolic resins such as novolaks and resols, and copolymers of (meth)acrylic acid, N-phenylmaleimide and (meth) acrylamide (see DE 199 36 331).

Further suitable binders are "reactive binders", i.e. polymeric binders having side chains comprising free radical polymerizable groups. For example the reactive side groups are selected from acryl, methacryl, styryl, allyl, and mixtures of two or more thereof. The polymer backbone is not limited and is for example selected from an acrylic backbone, methacrylic backbone, acetal backbone, urethane backbone, and styrene backbone; copolymers of the aforementioned are also possible. Suitable reactive binders are disclosed in a number of patent applications e.g. WO 2004/014652 A1, WO 89/06659 A1, DE 29 03 270 A1, WO 95/12147, EP 410 242, and US 4,035,321.

The total amount of binders is preferably 5 to 95 wt-%, based on the dry layer weight, especially preferred 10 to 85 wt-%.

*NEGATIVE DIAZO-SYSTEMS (UV-SENSITIVE)*

Another type of negative working UV-sensitive coating - applied onto a substrate - comprises a diazonium polycondensation product.

Diazonium polycondensation products known to the person skilled in the art can be used as diazonium polycondensation product. Such condensation products can for example be prepared according to known methods by condensing a diazo monomer described in EP-A-0 104 863 with a condensation agent such as formaldehyde, acetaldehyde, propionaldehyde, butyraldehyde, isobutyraldehyde or benzaldehyde. Furthermore, co-condensation products are used which in addition to the diazonium salt units also comprise other units which are not photosensitive and are derived from condensable compounds, in particular aromatic amines, phenols, phenol ethers, aromatic thiolethers, aromatic hydrocarbons, aromatic heterocycles and organic acid amides. Especially advantageous examples of the diazonium polycondensation products include reaction products of diphenylamine-4-diazonium salts, which optionally contain a methoxy group in the phenyl group carrying the diazo group, and formaldehyde or 4,4'-bismethoxymethyldiphenylether. Aromatic sulfonates such as 4-tolylsulfonate or mesitylene sulfonate, tetrafluoroborate, hexafluorophosphate, hexafluoroantimonate and hexafluoroarsenate are especially suitable as anions of these diazo resins. The diazonium polycondensation product is preferably present in an amount of 3 to 60 wt-% in the photosensitive composition.

Hybrid systems of diazonium polycondensation products and the above-mentioned UV-sensitive free-radical polymerizable system can also be used in the negative working radiation-sensitive coating.

Suitable binders for such systems are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt-%, based on the dry layer weight, especially preferred 10 to 85 wt-%.

*SINGLE-LAYER NEGATIVE WORKING IR-SENSITIVE ELEMENTS*

Another type of negative working single-layer IR-sensitive elements are elements wherein the radiation-sensitive layer on a substrate is rendered insoluble in or impenetrable by aqueous alkaline developer upon IR irradiation and comprises

(i) at least one compound which forms an acid upon the application of heat (in the following also referred to as "latent Bronsted acid"), and

(ii) a component cross-linkable by an acid (in the following also referred to as "cross-linking agent") or a mixture thereof and

(iii) at least one IR absorber.

Systems based on this principle are for example described in EP 0 625 728 B1 and EP 0 938 413 B1.

All the sensitizers described above which absorb radiation from the IR range (more than 750 to 1,200 nm) can be used as IR absorbers.

Ionic and nonionic Bronsted acids can be used as latent Bronsted acid. Examples of ionic latent Bronsted acids include onium salts, in particular iodonium, sulfonium, oxysulfoxonium, oxysulfonium, phosphonium, selenonium, telluronium, diazonium and arsonium salts. Specific examples are diphenyliodonium-hexafluorophosphate, triphenylsulfonium-hexafluoroantimonate, phenylmethyl-ortho-cyanobenzylsulfonium-tri-fluoromethanesulfonate and 2-methoxy-4-aminophenyl-diazonium-hexafluorophosphate.

Examples of nonionic latent Bronsted acids include $RCH_2X$, $RCHX_2$, $RCX_3$, $R(CH_2X)_2$ and $R(CH_2X)_3$, wherein X represents Cl, Br, F or $CF_3SO_3$ and R is an aromatic, aliphatic or araliphatic group.

Ionic latent Bronsted acids of the formula

$$X^{\oplus}R^{1a}R^{1b}R^{1c}R^{1d}W^{\ominus}$$

are also suitable, wherein if X represents iodine, $R^{1c}$ and $R^{1d}$ are free electron pairs and $R^{1a}$ and $R^{1b}$ are aryl groups or substituted aryl groups,

if X represents S or Se, $R^{1d}$ is a free electron pair and $R^{1a}$, $R^{1b}$, $R^{1c}$ are independently selected from aryl groups, substituted aryl groups, an aliphatic group or substituted aliphatic group, if X represents P or As, $R^{1d}$ can be an aryl group, substituted aryl group, aliphatic group or substituted aliphatic group, and

wherein $W^{\ominus}$ is selected from $BF_4^{\ominus}$, $CF_3SO_3^{\ominus}$, $SbF_6^{\ominus}$, $CCl_3CO_2^{\ominus}$, $ClO_4^{\ominus}$, $AsF_6^{\ominus}$ or $PF_6^{\ominus}$.

$C_1$-$C_5$-alkyl sulfonates, arylsulfonates (e.g. benzoin tosylate, 2-hydroxymethylbenzoin tosylate and 2,6-dinitrobenzyl tosylate) and N-$C_1$-$C_5$-alkyl-sulfonylsulfonamides (e.g. N-methanesulfonyl-p-toluene-sulfonamide and N-methanesulfonyl-2,4-dimethylbenzenesulfonamide) are also suitable.

Specific suitable onium compounds are for example listed in detail in US 5,965,319 as formulas (I) to (III).

The latent Bronsted acids are preferably used in an amount of 0.5 to 50 wt-%, especially preferred 3 to 20 wt-%, based on the dry layer weight.

The cross-linking agent can for example be a resin, selected from resols, $C_1$-$C_5$-alkoxymethylmelamines, $C_1$-$C_5$-alkoxymethyl-glycoluril resins, poly($C_1$-$C_5$-alkoxy-methylstyrenes) and poly($C_1$-$C_5$-alkoxymethylacrylamides), epoxidized novolak resins and urea resins. In particular, compounds comprising at least 2 groups in a molecule, selected from hydroxymethyl, alkoxymethyl, epoxy and vinylether groups, bonded to an aromatic ring, can be used as cross-linking agents; of those, phenol derivatives with at least 2 groups selected from hydroxymethyl and alkoxymethyl groups, bonded to a benzene ring, 3 to 5 benzene rings and a molecular weight of 1,200 or less, as listed in columns 31 to 37 of US 5,965,319, are preferred.

The cross-linking agent is preferably used in an amount of 5 to 90 wt-%, based on the dry layer weight, especially preferred 10 to 60 wt-%.

The radiation-sensitive layers of this type can contain binders, for example selected from alkalisoluble or dispersible (co)polymers, such as novolaks, acetone pyrogallol resin, polyhydroxystyrenes and hydroxystyrene-N-substituted maleimide-copolymers as listed in US 5,965,319 as component (C), polymers as mentioned in US 5,919,601 as binder resins and copolymers as described in DE 199 36 331.

Preferably binders are present in an amount of 5 to 95 wt-%, based on the dry layer weight, especially preferred 5 to 60 wt-%.

In principle, known IR-sensitive elements with a single-layer structure, as for example described in US 5,919,601 and WO 00/17711 A1, can be processed according to the present invention.

*<u>Positive working radiation-sensitive elements</u>*

*UV-SENSITIVE*

Positive working UV-sensitive elements can for example be based on quinone diazides (preferably naphthoquinone diazides) and novolaks, as for example described in US 4,594,306.

Suitable binders for such coatings are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt-%, based on the dry layer weight, especially preferred 10 to 85 wt-%.

*IR-SENSITIVE*

There are numerous examples of positive working IR-sensitive elements, which can be divided into two groups: those with a radiation-sensitive coating comprising only one layer and those where the radiation-sensitive coating comprises at least two layers.

*Single-layer plates*

Usually, single-layer positive working IR-sensitive elements comprise

(a) an optionally pretreated substrate
(b) a positive working heat-sensitive layer comprising

(i) at least one polymer soluble in aqueous alkaline developer, such as e.g. a novolak resin,
(ii) at least one component which reduces the aqueous alkaline developer solubility of the developer soluble polymer (e.g. novolak), wherein said reduction in solubility is reversed upon the application of heat ("insolubilizer"), and
(iii) optionally an IR absorber (i.e. a compound which absorbs IR radiation and converts it to heat),

wherein components (i) and (ii) do not have to be present as separate substances but can be used in the form of an accordingly functionalized novolak. It is also possible to use an IR absorber that also acts as insolubilizer. Such single-layer IR-sensitive positive working elements are for example described in EP 825 927 B1.

Polymers with hydroxyl, carboxylic acid, amino, amide and maleimide groups can for example be used as polymers soluble in aqueous alkaline developer. In particular, these compounds include phenolic resins, copolymers of 4-hydroxystyrene and 3-Methyl-4-hydroxystyrene or 4-methoxystyrene, copolymers of (meth)acrylic acid and styrene, copolymers of maleimides and styrene, hydroxy- or carboxy-functionalized celluloses, copolymers of maleic acid anhydride and styrene and partially hydrolyzed polymers of maleic acid anhydride. Phenolic acids, in particular novolak, are especially preferred.

Suitable novolak resins are condensation products of phenols, e.g. phenol itself, C-alkyl-substituted phenols (including cresols, xylenols, p-tert-butylphenol, p-phenylphenol and nonyl phenols) and diphenols (e.g. bisphenol-A), with suitable aldehydes such as formaldehyde, acetaldehyde, propionaldehyde, and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" and having a thermoplastic character. However, as used in the present application, the term "novolak resin" should also encompass the phenolic resins known as "resols" which are obtained at higher aldehyde/phenol ratios and in the presence of alkaline catalysts.

Based on the dry layer weight, the novolak resin is preferably present in an amount of at least 40 wt-%, more preferred at least 50 wt-%, even more preferred at least 70 wt-% and particularly preferred at least 80 wt-%. Usually, the amount does not exceed 95 wt-%, more preferred 85 wt-%.

The chemical structure of the IR absorber is not particularly restricted as long as it is capable of converting the absorbed radiation into heat. The IR absorbers mentioned above in connection with photopolymerizable IR-sensitive elements can be used. The IR absorber is preferably present in an amount of at least 0.1 wt-% based on the dry layer weight, more preferred at least 1 wt-%, and particularly preferred at least 2 wt-%. Usually, the amount of IR absorber does not exceed 25 wt-%, more preferred 20 wt-% and particularly preferred 15 wt-%. Either a single IR absorber or a mixture of two or more can be present; in the latter case, the amounts given refer to the total amount of all IR absorbers.

The amount of IR absorber to be used also has to be considered in view of the dry layer thickness of the coating. It should preferably be selected such that the optical density of the coating - measured for example on a transparent polyester film - preferably shows values between 0.4 and 1.0 at the wavelength of the IR light with which the coating is irradiated.

The IR-sensitive coating furthermore comprises at least one substance that reduces the aqueous alkaline developer solubility of the polymer like novolak, whereby this reduction in solubility is reversed by the application of heat. In the following, this substance is briefly referred to as "insolubilizer". The insolubilizer may or may not be covalently bonded to a polymer.

Use can be made of insolubilizers already described in the prior art or of different ones.

Suitable insolubilizers include for example the compounds described in WO 98/42507 and EP-A 0 823 327 which are not photosensitive and comprise functional groups that can enter into a hydrogen bond with the phenolic OH groups of novolak resins. WO 98/42507 mentions sulfone, sulfoxide, thion, phosphinoxide, nitrile, imide, amide, thiol, ether, alcohol, urea, nitroso, azo, azoxy and nitro groups, halogens and in particular keto groups as suitable functional groups. Xanthone, flavanone, flavone, 2,3-diphenyl-1-indenone, pyrone, thiopyrone and 1'-(2'-acetonaphthonyl)benzoate are mentioned as examples of suitable compounds.

In WO 99/01795, polymers with specific functional groups Q which preferably do not comprise diazide groups, acid groups or acid-forming groups are used as insolubilizers, and according to a preferred embodiment, Q is selected from amino, monoalkylamino, dialkylamino, amido, monoalkylamido, dialkylamido groups, fluorine atoms, chlorine atoms, carbonyl, sulfinyl or sulfonyl groups. These polymeric insolubilizers can also be used in the present invention.

The insolubilizers described in WO 99/01796, in this case compounds with diazide units, can be used in the present invention as well.

Another group of insolubilizers suitable for use in the present invention is described in WO 97/39894. They are e.g. nitrogen-containing compounds wherein at least one nitrogen atom is quaternized and forms part of a heterocyclic ring; examples include e.g. quinolinium compounds, benzothiazolium compounds and pyridinium compounds, and in particular cationic trimethylmethane dyes such as Victoria Blue (C I Basic Blue 7), crystal violet (C I Basic Violet 3) and ethyl violet (C I Basic Violet 4). Furthermore, compounds with carbonyl function such as N-(4-bromobutyl)-phthalimide, benzophenone and phenanthrenequinone are mentioned. Compounds of the formula $Q_1$-S(O)$_n$-$Q_2$ (wherein $Q_1$ = optionally substituted phenyl or alkyl group; n = 0, 1 or 2; $Q_2$ = halogen atom or alkoxy group), Acridine Orange Base and ferrocenium compounds can be used as well.

If the IR absorbers comprise the structural elements mentioned in WO 97/39894, they also function as insolubilizers.

The functionalized novolaks described in US 6,320,018 B can be used in the heat-sensitive elements of the present invention as well. These novolaks contain substituents which allow a two- or four-center hydrogen bond (preferably a four-center hydrogen bond, also named quadrupol hydrogen bonding QHB) between the polymer molecules. This also decreases the aqueous alkaline developer solubility of the underlying novolak. Such hydrogen bonds are broken by heating and the original solubility of the novolak is restored. If such a functionalized novolak is used, it assumes the function of components (i) and (ii) of the heat-sensitive composition so that the additional use of a novolak without corresponding functional groups and/or an insolubilizer as described above is not necessary, but not excluded, either.

The functionalized novolaks comprise at least one covalently bonded unit and at least one non-covalently

bonded unit, with the non-covalent bond being thermally unstable; these novolaks have a two- or four-center hydrogen bond at essentially every non-covalently bonded unit. A preferred group of such functionalized novolaks which can be used as novolak with a simultaneous insolubilizing function can be described with the following formula (XIV):

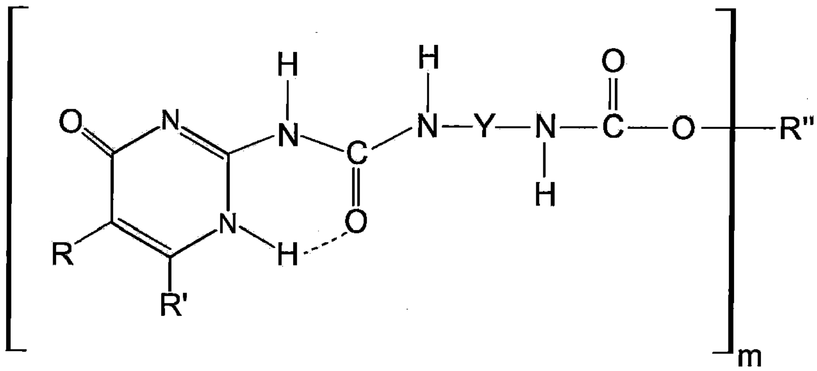

(XIV)

wherein R and R' are independently selected from a hydrogen atom and a cyclic or straight or branched saturated or unsaturated hydrocarbon group with preferably 1 to 22 carbon atoms (preferably hydrogen and $C_1$-$C_4$ alkyl), R" is a phenolic group derived from a novolak $R''(OH)_p$, Y is a divalent cyclic or straight or branched saturated or unsaturated hydrocarbon group with preferably 1 to 22 carbon atoms derived from a diisocyanate of the formula $Y(NCO)_2$ (e.g. isophorone diisocyanate, toluene-1,2-diisocyanate, 3-isocyanatomethyl-1-methylcyclohexylisocyanate), m is at least 1 and p is 1 or 2.

The preparation of functionalized novolaks of formula (XIV) can e.g. be inferred from US 2002/0,150,833 A1.

Another class of suitable functionalized resins, such as e.g. functionalized phenolic resins and in particular functionalized novolaks, is disclosed in US 6,537,735 B. While the non-functionalized resin is soluble in aqueous alkaline developer, the functionalized resin is insoluble in the developer; however, the application of heat (for example generated by IR radiation) renders it soluble in the developer. Preferably, the non-functionalized resin comprises OH or SH groups which in the functionalized resin are at least partially converted to covalently bonded functional groups Q; preferably, the functional groups Q are formed via an esterification reaction of the OH groups and are preferably selected from -O-$SO_2$-tolyl, -O-dansyl, -O-$SO_2$-thienyl, -O-$SO_2$-naphthyl and -O-CO-phenyl. The ratio of functional groups Q to OH groups is preferably 1:100 to 1:2, more preferred 1:50 to 1:3. The novolak resins, resols, acrylic resins with phenolic side chains and hydroxystyrenes described above can for example be used as non-functionalized resins. An especially preferred functionalized resin of this class is a phenolic resin (preferably a novolak), partially (e.g. 10 to 20%) esterified with toluenesulfonic acid or sulfonic acid chloride; however, all the other functionalized resins described in US 6,537,735 can be used in the present invention as well.

Although all the insolubilizers mentioned above can be used in the heat-sensitive coating of the present invention, the following are preferred: Cyanine dyes, triarylmethane dyes, quinolinium compounds, the above insolubilizers with (a) keto group(s) and the above insolubilizers with (a) sulfone group(s), as well as novolaks functionalized with substituents capable of forming four-center hydrogen bonds. The cyanine dyes, triarylmethane dyes, quinolinium compounds, ketones and sulfones can be used as low-molecular substances or bonded to a polymer.

A single insolubilizer or mixtures of two or more compounds can be used in the heat-sensitive elements of the present invention.

The amount of insolubilizer(s) is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas.

Independently of whether the insolubilizer also functions as IR absorber, it is preferably present in an amount of at least 0.1 wt-% based on the dry layer weight, more preferred at least 0.5 wt-%, especially preferred at least 1 wt-% and particularly preferred at least 2 wt-%. Preferably, no more than 25 wt-%, more preferred no more than 15 wt-%, are used.

Optional binders are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 1 to 99 wt-%, based on the dry layer weight, especially preferred 10 to 98 wt-%.

*Dual-layer plates*

IR sensitive elements useful in the present invention can also be positive working dual-layer elements wherein a first layer is provided on the hydrophilic surface of the substrate which is soluble in aqueous alkaline developer and a top layer ("masking layer") on top of the first layer which is not dispersible or soluble in and not penetrable by an aqueous alkaline developer, and which is rendered soluble or dispersible in or penetrable by the developer by IR irradiation.

Suitable binders for the first ("lower") layer of such dual-layer positive working IR-sensitive elements are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The binders are preferably present in an amount of 5 to 99 wt-%, based on the dry layer weight, especially preferred 10 to 98 wt-%.

An IR absorber ("photothermal conversion material") is present in the first layer, or the top layer or in both layers; it can also be present in a separate "absorber layer". Preferably the IR absorber is present in the first layer.

The chemical structure of the IR absorber is not particularly restricted as long as it is capable of converting the absorbed IR radiation into heat. The IR absorbers mentioned above in connection with photopolymerizable IR-sensitive elements can be used. The IR absorber is preferably present in an amount of at least 1 wt-% based on the dry layer weight of the layer in which it is present, more preferred at least 2 wt-%, and particularly preferred at least 5 wt-%. Usually, the amount of IR absorber does not exceed 35 wt-%, more preferred 30 wt-% and particularly preferred 25 wt-% of the layer in which it is present. If the IR absorber is only present in the first layer, its amount in said layer is preferably from 10 to 20 wt-%, based on the dry layer weight of the first layer. Either a single IR absorber or a mixture of two or more can be present; in the latter case, the amounts given refer to the total amount of all IR absorbers present in one layer.

The top layer protects the first layer from being dissolved by an aqueous alkaline developer. It is therefore necessary that the top layer itself is not soluble or dispersible in or penetrable by an aqueous alkaline developer. By the wording "not soluble in, dispersible in or penetrable by an aqueous alkaline developer", it is meant that the top layer can resist the attack of an aqueous alkaline developer having a pH of at least 8 for at least 2 minutes. However, upon exposure to IR radiation the top layer becomes removable by an aqueous alkaline developer (necessary dwell time: less than 2 minutes).

Various dual-layer plates are known in the art, however, the mechanisms of change of solubility/dispersibility/penetrability due to exposure to IR radiation are still not fully understood. Such dual-layer systems are for instance described in US 6,352,812, US 6,352,811, US 6,358,669, US 2002/0,150,833 A1, US 6,320,018, US 6,537,735 and WO 02/14071, In principle, the following types of top layers are known:

a) The top layer comprises a polymer like a novolak which itself is soluble/dispersible in an aqueous alkaline developer and an "insolubilizer" which reduces the solubility/dispersibility to such a high degree that the layer is not soluble or penetrable under developing conditions. The interaction between the polymer and the inhibitor is deemed to be weakened by IR radiation to such a degree that the irradiated (heated) areas of the layer are rendered soluble/dispersible in or penetrable by the developer. Such systems are for example described in US 6,352,811 and US 6,358,669. The polymer/insolubilizer systems can be the same as those described above for single layer plates.

b) The top layer comprises a polymer like a novolak which as such is soluble/dispersible in an aqueous alkaline developer but which has been chemically modified (for instance by chemically binding an "insolubilizer") so that it is not soluble/dispersible/penetrable by an aqueous alkaline developer. Such functionalized resins (like e.g. functionalized novolaks) are for instance described in US 2002/0,150,833 A1, US 6,320,018 B and US 6,537,735 B.

The top layer can also comprise a polymer which is not soluble/dispersible in an aqueous alkaline developer at usual developing conditions (i.e. the top layer can resist the attack of a developer for at least 2 minutes).

It is assumed that either there are any interactions within the top layer which are weakened by IR radiation or microcracks and/or bubbles are formed in the top layer or in the interface between first layer and top layer due to exposure to IR radiation (and the heat created thereby) which allows removal of the initially insoluble/inpenetrable top layer together with the soluble bottom layer by the developer in the exposed areas.

Polymers and copolymers with phenolic OH groups, i.e. phenolic resins, are preferably used for a top layer of the type (a) as described above. Suitable phenolic resins include e.g. novolaks, resols, acrylic resins with phenolic side chains and polyvinyl phenolic resins, whereby novolaks are especially preferred.

Novolak resins suitable for the present invention are condensation products of suitable phenols, e.g. phenol itself, C-alkyl-substituted phenols (including cresols, xylenols, p-tert-butylphenol, p-phenylphenol and nonylphenols), and of diphenols (e.g. bisphenol-A), with suitable aldehydes such as formaldehyde, acetaldehyde, propionaldehyde and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" which have a thermoplastic character.

As used in the present application, however, the term "novolak resin" should also encompass the phenolic resins known as "resols" which are obtained at higher aldehyde/phenol ratios and in the presence of alkaline catalysts.

The amount of insolubilizer(s) in a top layer of type (a) above is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas.

The insolubilizer is preferably present in an amount of at least 0.1 wt-% based on the dry layer weight, more preferred at least 0.5 wt-%, especially preferred at least 2 wt-% and particularly preferred at least 5 wt-%. Preferably, no more than 40 wt-%, more preferred no more than 25 wt-%, are used.

Polymers useful for a top layer of type (b) are for instance functionalized novolaks like those of formula (XII) mentioned above and functionalized phenolic resins like those mentioned in US 6,537,735 B (e.g. tosylated novolaks), see also above under the headline "Single-layer plates". Modified alkylphenol resins (like those commercially available from Schenectady under the trade name SP1077 and HRJ302) as well as novolaks based on xylenol and cresol (like those commercially available from AZ-Electronics under the trade name SPN-572) are also useful for a top layer of type (b).

*Optional components*

Independently of whether the element is UV/VIS- or IR-sensitive, the radiation-sensitive coating can comprise one or more of the following optional components in addition to the essential components. If the coating consists of several layers, the optional component(s) can be present in one, several or all of the layers.

Dyes or pigments having a high absorption in the visible spectral range can be present in order to increase the contrast ("contrast dyes and pigments"). Particularly suitable dyes and pigments are those that dissolve well in the solvent or solvent mixture used for coating or are easily introduced in the disperse form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer weight.

Furthermore, the layer(s) can comprise surfactants (e.g. anionic, cationic, amphoteric or non-ionic tensides or mixtures thereof). Suitable examples include fluorine-containing polymers, polymers with ethylene oxide and/or propylene oxide groups, sorbitol-tri-stearate and alkyl-di-(aminoethyl)-glycines. They are preferably present in an amount of 0 to 10 wt-%, based on the dry layer weight, especially preferred 0.2 to 5 wt-%.

The layer(s) can furthermore comprise print-out dyes such as crystal violet lactone or photochromic dyes (e.g. spiropyrans etc.). They are preferably present in an amount of 0 to 15 wt-%, based on the dry layer weight, especially preferred 0.5 to 5 wt-%.

Also, flow improvers can be present in the layer(s), such as poly(glycol)ether-modified siloxanes; they are preferably present in an amount of 0 to 1 wt-%, based on the dry layer weight.

The layer(s) can furthermore comprise antioxidants such as e.g. mercapto compounds (2-mercaptobenzimidazole, 2-mercaptobenzthiazole, 2-mercaptobenzoxazole and 3-mercapto-1,2,4-triazole), and triphenylphosphate. They are preferably used in an amount of 0 to 15 wt-%, based on the dry layer weight, especially preferred 0.5 to 5 wt-%.

*Overcoat*

An overcoat can be applied over the photopolymerizable coating for protecting the coating from atmospheric oxygen during storage, exposure and in particular during the time between exposure and further processing. During that time the overcoat has to exhibit sufficient adhesion to the light-sensitive coating so that safe handling (manufacture, packing, transport, exposure etc.) is guaranteed without tearing of the layers. In addition to its function as oxygen barrier layer the overcoat also protects the photopolymerizable coating from fingerprints and mechanical damage like scratches.

A number of water-soluble polymers are described in the literature as being suitable for such overcoats. Suitable examples are polyvinyl alcohol, partly saponified polyvinyl acetate which can also contain vinylether and vinylacetal units, polyvinyl pyrrolidone and copolymers thereof with vinyl acetate and vinyl ethers, hydroxy alkyl cellulose, gelatin, polyacrylic acid, gum arabic, polyacryl amide, dextrin, cyclodextrin, copolymers of alkylvinyl ethers and maleic acid anhydride as well as water-soluble high molecular polymers of ethylene oxide having molecular weights of above 5,000 are particularly suitable. Polyvinyl alcohol is a preferred overcoat polymer. Also polyvinyl alcohol in combination with poly(1-vinylimidazole) or a copolymer of 1-vinyl-imidazole and at least one further monomer as described in WO 99/06890 can be used.

Polyvinyl alcohol can also be used in combination with polyvinyl pyrrolidone as adhesive.

Overcoats are also described in US 3,458,311, US 4,072,527, US 4,072,528, EP 275 147 A1, EP 403 096 A1, EP 354 475 A1, EP 465 034 A1 and EP 352 630 A1.

In a preferred embodiment the overcoat comprises polyvinyl alcohol or polyvinyl alcohol in combination with poly(1-vinylimidazol) (or a copolymer thereof).

Suitable polyvinyl alcohols are commercially available at inexpensive prices. They usually have a residual content of acetate groups in the range of 0.1 to 30 wt-%. Especially preferred are polyvinyl alcohols obtained from polyvinylacetate with a residual acetate content of 1.5 to 22 wt-%. By means of the molecular weight of the used polyvinyl alcohols, adhesion and water-solubility of the overcoats can be controlled. A lower molecular weight promotes the removal of the overcoat with aqueous solutions.

The water-soluble overcoats can be applied by means of surface coating methods known to the skilled practician such as doctor blade coating, roller coating, slot coating, curtain coating, spray or dipping processes. Dry layer weights of from 0.05 to 10 g/m$^2$, more preferably 0.2 to 3 g/m$^2$, most preferably 0.3 to 1 g/m$^2$ are suitable.

In many cases it is favorable to apply the water-soluble overcoats in an aqueous solution. This has the least detrimental effects on the environment and the human body.

For some applications, however, it can also be favorable to use organic solvents. In some substrates the addition of 0.5 to 60 wt-% of an organic solvent to the aqueous coating solution improves adhesion. By means of a slight solvation of the surface to be overcoated, the adhesive effect of the polymers of the overcoats according to the present invention is increased further. Such additives to solvents can e. g. be alcohols or ketones.

For a uniform and rapid wetting of the surface to be coated, anionic, cationic or non-ionic wetting agents may be added to the coating solutions. The overcoat furthermore can comprise stabilizers, preservatives, dyeing agents, foam separators and rheological additives.

*IMAGEWISE EXPOSURE*

If the absorber component used in the photopolymerizable coating absorbs UV/VIS radiation, the precursors are imagewise exposed in a manner known to the person skilled in the art with UV/VIS radiation of a wavelength of 250 to 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 $\pm$ 10 nm), argon ion lasers emitting in the visible range (488 nm or 514 nm) and frequency-doubled fd:Nd:YAG lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range of more than 750 to 1,200 nm, and preferably shows an absorption maximum in this range in its absorption spectrum, imagewise exposure can be carried out with IR radiation sources. Suitable radiation sources are e.g. semi-conductor lasers or laser diodes which emit in the range of 750 to 1200 nm, for example Nd:YAG lasers (1,064 nm), laser diodes which emit between 790 and 990 nm, and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

The imagewise exposed precursor comprises exposed and unexposed areas of the coating.

Any embodiment described with respect to the imagewise exposure can be combined with any suitable embodiment of the invention described above or below with respect to other aspects of the invention.

*PROCESSING OF THE EXPOSED PRECURSOR*

After exposure the precursor is treated with a developer in order to remove the coating in the non-image areas thereby revealing the substrate in said areas; if the precursor was a positive working one, the non-image areas correspond to the exposed areas while for negative working precursors the non-image areas correspond to the unexposed areas. According to one embodiment a preheat step is carried out between exposure and treating with the developer.

If the precursor comprises an overcoat which protects the radiation sensitive coating, the overcoat can be removed by washing/rinsing with water before applying the developer.

After removing the non-image areas of the coating (and optionally the overcoat) with the developer, the treated precursor can be dried.

According to one embodiment the treated precursor can be rinsed with water after removing the non-image areas of the coating (and optionally the overcoat) with the developer.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be

carried out in a commercially available processor, equipped with an immersion type developing bath, a section for rinsing with water, a gumming section, and a drying section, can be used. Additionally, a conductivity-measuring unit can be incorporated into the processor for controlling the developer activity of the developer.

The exposed precursor is typically treated with the developer at a temperature of 18˚C to about 28˚C, for a period of about 5 seconds to about 60 seconds.

After a certain number of exposed precursors have been processed, the developing activity (for instance measured by titration or conductivity measurement) of a developer bath falls below a predetermined level. Then fresh developer is added to the bath (also called "top-up" process). Usually about 20 mL to about 200 mL, typically about 30 to 120 mL, of fresh developer per 1 $m^2$ of precursor processed is necessary to keep both the volume of developer and its activity/conductivity value constant. The processed lithographic printing plate, comprises regions in which imageable layer has been removed revealing the underlying surface of the hydrophilic substrate, and complimentary regions in which the imageable layer has not been removed. The regions in which the imageable layer has not been removed are ink receptive.

Instead of adding fresh developer for keeping the activity of the developer bath constant a replenisher can be added. The replenisher suitably differs from the fresh developer in that the concentration of the alkaline reagent is higher compared to the concentration of the alkaline reagent in the fresh developer used; the concentration of the other components might be the same or higher as in the fresh developer.

After having contacted the precursor with the developer any excess of said developer remaining on the precursor can be removed for instance by means of squeeze rollers; washing/rinsing the precursor with a liquid like water etc. is also possible.

The developer used in the present invention is not particularly limited, but any developer which is capable of removing the non-image areas can be used; usually the developer is an aqueous alkaline solution. Said aqueous alkaline solution can for instance contain an alkali metal silicate, an alkali metal hydroxide or carbonate for obtaining an pH of >6, preferably 8-14. The developer can optionally also contain a small amount of an organic solvent, a surfactant, a thickener, dyes, odorants, polymers, oligomers, antioxidants and mixtures thereof.

Any embodiment described with respect to the processing can be combined with any suitable embodiment of the invention described above or below with respect to other aspects of the invention.

*FINISHING TREATMENT*

For the finishing treatment of the imaged lithographic printing plate (obtained either by imagewise exposure and development or by imagewise applying printing areas to the substrate) according to the present invention a solution of the hydrophilic polymer is prepared. This solution is then applied using common coating processes such as e.g. dip coating, roller coating, spray coating, coating with a doctor blade and coating with a slot coater. The solution used in this process has a temperature of preferably 20 to 90˚C. The finishing treatment according to the present invention can also be carried out in a plate developing machine ("processor"). In any case it is a treatment before the plate is mounted on a press and is contacted with printing ink and fountain solution.

The printing plate treated with the solution is then dried, for example in the air or by means of a hot-air dryer or an infrared dryer. Drying is preferably carried out at a temperature of 20 to 120˚C, especially preferred 20 to 80˚C.

Any embodiment described with respect to the finishing treatment can be combined with any suitable embodiment of the invention described above or below with respect to other aspects of the invention.

*Finishing Solution*

*Water*

Tap water, deionized water or distilled water can be used. The amount of water is preferably in the range of 45 to 98 wt-%, based on the total weight of the finishing solution, especially preferred 50 to 95 wt-% and particularly preferred 80 to 95 wt-%.

*Hydrophilic polymer*

The hydrophilic polymer used in the finishing solution according to the present invention comprises

(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50.

The acidic functional groups present in the hydrophilic polymer can all be in the form of a free acid, or all of said groups are in the form of a salt, or a part thereof is in the form of a free acid and the remaining part is in the form of a salt. When reference is made to the acidic functional group(s) in connection with the hydrophilic polymer this should include free acidic groups, salts and mixtures thereof unless defined otherwise.

It is essential for the hydrophilic polymer that it comprises both amino groups and acid groups.

Optionally the hydrophilic polymer comprises (m3) alkylene oxide units $-(CHR^1-CH_2-O)_p-$wherein each $R^1$ independently represents H or $-CH_3$ and p is an integer from 1 to 50. The alkylene oxide units can be present in the polymer backbone or in side chains. According to one embodiment the alkylene oxide units are present in side chains as spacer between the backbone and the acid groups and/or amino groups.

The acid groups are selected from -COOH, $-SO_3H$, $-PO_2H_2$ and $-PO_3H_2$; the preferred acid group is -COOH. Mixtures of different acid groups within one polymer molecule are also possible.

It is also possible to introduce ester groups as long as the hydrophilic polymer has the capability to hydrophilize the substrate in the no-image areas to avoid toning on press. One representative example are sulfobetaines, that is [2-(methacryloyloxy)-ethyl]-dimethyl-(3-sulfopropyl)-ammonium hydroxide

One polymer molecule can comprise primary, secondary or tertiary amino groups. It is also within the scope of the present invention that one polymer molecule comprises a mixture of primary and secondary amino groups, primary and tertiary amino groups, secondary and tertiary amino groups or a mixture of primary and secondary and tertiary amino groups. In addition, also amino groups with quaternized nitrogen atom are possible; in such a case, suitable counter anions like are required. There are lots of anions possible as long as the substrate surface of the no-image areas maintains its hydrophilicity. Preferred anions are halides, phosphates, phosphonates, sulfates, tetrafluoro borates, hexafluorophosphates and others. In case that half esters with organic acids are used it is recommended to chose such a chain length that the anions does not become too hydrophobic.

According to one embodiment, the amino groups are bound to the polymer backbone either directly or via a spacer; suitable spacers are for instance $C_1$-$C_4$ alkylene groups. It is preferred within this embodiment that the amino groups are directly bound to a carbon atom of the polymer backbone; according to one embodiment, the hydrophilic polymer comprises structural units with amino groups represented by the following formula

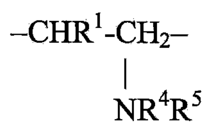

wherein $R^1$ is H or $CH_3$ and $R^4$ and $R^5$ are independently selected from H, alkyl, aryl, and alkylaryl. The nature of the substituent is chosen in such a way that the hydrophilicity of the polymer is high enough for efficient hydrophilization of the no-image areas that in order to avoid toning on press. A good guess for incorporation of appropriate groups is the solubility parameter, which is described in more detail in D. W. van Krevelen, "Properties of Polymers: Their Correlation with Chemical Structure; Their Numerical Estimation and Prediction From Additive Group Contributions", Elsevier, 2003, 3rd Edition, ISBN 044482877X.

The hydrophilic polymer used in the present invention should have a sufficiently high hydrophilicity to avoid toning of the printing plate. One possibility of defining the hydrophilicity is to calculate the solubility parameter $\delta$, which is a quantity defining the solubility of component A in component B. A may be the polymer while B is the solvent. This is well reviewed and explained in D. W. van Krevelen, Properties of Polymers, Elsevier, 3rd edition, Amsterdam, 2003.

According to the assumption of Hansen:

$$\delta_t^2 = \delta_d^2 + \delta_p^2 + \delta_h^2$$

wherein t = total

d = dispersed forces
p = polar forces
h = hydrogen bonding

According to the method of Hoftyzer and Van Krevelen

$$\delta_d = \frac{\sum F_{di}}{V_m}$$

$$\delta_p = \frac{\sqrt{\sum F_{pi}^2}}{V_m}$$

$$\delta_h = \sqrt{\frac{\sum E_{hi}}{V_m}}$$

wherein $F_{di}$ (in $J^{1/2} \cdot cm^{3/2} \cdot mol^{-1}$) are the group contributions to the dispersion component $F_d$ of the molar attraction constant, $F_{pi}$ (in $J^{1/2} \cdot cm^{3/2} \cdot mol^{-1}$) are the group contributions to the polar component $F_p$ of the molar attraction constant, $E_{hi}$ (in $J \cdot mol^{-1}$) is the hydrogen bonding energy per structural group, and $V_m$ (in $cm^3 \cdot mol^{-1}$) is the molar volume.

For the present invention it is considered sufficient to concentrate on $\delta_h$, which relates to the solubility in polar solvents and gives a certain measure for the hydrophilicity. The following table shows the hydrogen bonding energies $E_h$ for several groups. It is clear from this table that polar groups strongly contribute to $\delta_h$ while the incorporation of hydrophobic substituents has no impact on $\delta_h$ but only results in an overall change of $\delta$. Thus, the appropriate incorporation of additional substituents with even hydrophobic properties can be done as long as the overall solubility parameter $\delta$does not strongly decrease.

Within the present invention a polymer is considered hydrophil if its $\delta_h$ calculated as shown above is at least 10 $J^{0.5}/cm^{1.5}$.

| | $E_{hi}$ (in $J \cdot mol^{-1}$) |
|---|---|
| $-CH_3$ | 0 |
| $-CH_2-$ | 0 |
| -CH- | 0 |
| -C- | 0 |
| $=CH_2$ | 0 |
| =CH | 0 |
| =C | 0 |
| -Cyclohexyl | 0 |
| -Phenyl | 0 |
| -Phenyl(o,mp) | 0 |
| -Cl | 400 |
| -CN | 2500 |
| -OH | 20000 |
| -O | 3000 |

(continued)

| | $E_{hi}$ (in $J \cdot mol^{-1}$) |
|---|---|
| -COH | 4500 |
| -CO | 200 |
| -COOH | 10000 |
| -COO- | 7000 |
| $-NH_2$ | 8400 |
| -NH- | 3100 |
| -N- | 5000 |
| $-NO_2$ | 1500 |
| $=PO_4-$ | 13000 |

According to another embodiment, the nitrogen atom of the amino groups is not part of a side chain but is part of the polymer backbone. Hydrophilic polymers of this embodiment can for instance comprise following structural units (A1) in the backbone:

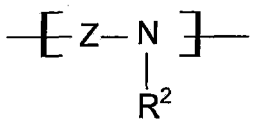

(A1)

wherein Z is a straight chain or branched $C_1$-$C_3$ (preferably $C_1$-$C_2$) alkylene group and each $R^2$ independently represents H, $C_1$-$C_4$ alkyl, phenyl or -X-AG with each X being independently selected from divalent straight chain or branched saturated or unsaturated hydrocarbons (e.g. $C_2$-$C_6$ alkylene and arylene), alkylene oxide including polyalkylene oxide, and ethylene imine including polyethylene imine, and each -AG independently representing an acid group as defmed above. If the amino group in (A1) is a terminal amino group, a second $R^2$ as defined above is present; it is also possible that an additional third $R^2$ is bound resulting in a quaternized nitrogen atom.

Spacer X is perferably a poly(alkylene)oxide or a poly(ethylene)imine.

If more than one unit (A1) is present in a polymer molecule, each Z and each $R^2$ is independently selected from the members given above.

According to one embodiment, the acid groups are bound to a carbon atom of the polymer backbone either directly or via a spacer; suitable spacers are for instance $C_1$-$C_4$ alkylene groups. For instance, the structural unit of the polymer comprising the acid group is represented by the following formula:

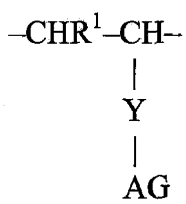

wherein $R^1$ is H or $CH_3$, Y is a single bond or a spacer, and AG is an acid group selected from -COOH, $-SO_3H$, $-PO_2H_2$ and $-PO_3H_2$, preferably -COOH.

Preferred spacer Y are alkyleneoxide, poly(alkylene)oxide, poly(ethylene)imine, ring opened lactones, ring opened lactames, ring opened anhydrides and carboxylic acids, and $C_xH_{2x}$ (x=1-6); especially preferred are poly (alkylene)oxide spacers.

According to another embodiment, the acid groups are bound to the nitrogen atoms of the amino groups via a spacer. It is especially preferred that in this case the nitrogen atom is part of the polymer backbone as shown in unit

(A1) above and further exemplified in unit (A1'):

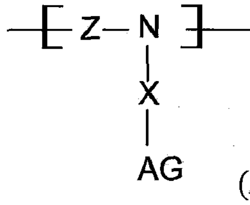

(A1')

with Z, X and AG being as defined above.

According to one embodiment of the present invention the hydrophilic polymers are derivatives of polyethylene imine or polyvinyl amine comprising acid groups AG.

The hydrophilic polymers can be prepared by polymerizing suitable monomers. For instance, monomers (c1) comprising one or more amino groups and monomers (c2) comprising one or more acid groups can be copolymerized resulting in hydrophilic polymers with acid groups and amino groups in side chains (i.e. acid and amino groups attached to the polymer backbone either directly or via a spacer). Suitable monomers with acid group are for instance acrylic acid, methacrylic acid, itaconic acid, crotonic acid, maleic acid anhydride ring opened with $C_1$ to $C_6$ alcohols, vinyl benzoic acid, vinylphosphonic acid, vinylsulfonic acid, vinylbenzenesulfonic acid, monoester of either hydroxyethyl methacrylate, hydroxyethyl acrylate or allylalcoholester of phosphoric acid, monoester of phosphoric acid with ethylene glycol methacrylate or ethylene glycol acrylate, monoester of phosphoric acid with polyethylene glycol methacrylate or ethylene glycol acrylate, sulfopropyl(meth)acryloylethyl dialkylammonium hydroxide.

Preferred examples for (c2) are either acrylic acid, methacrylic acid, vinylphosphonic acid, monoester of either hydroxyethyl(meth)acrylate or polyethyleneglycol (meth)acrylate with phosphoric acid, and (meth)acryloyldimethyl-(3-sulfopropyl)-ammonium hydroxide, maleinic acid, vinyl phosphonic acid, vinyl sulfuric acid.

Suitable monomers (c1) with amino group are for instance ethylene imin, propylene imine and vinyl amine.

Optionally, further comonomers (c3) like ethylene oxide, propylene oxide, lactones, lactames, vinyl alcohol, and vinyl methyl ether can be copolymerized with acid group containing monomers (c2) and amino group containing monomers (c1). In order to obtain a polymer with hydrophilic character which is preferably soluble in an aqueous solution having a pH of >6, the amount of such optional comonomers should be not more than 15 wt-% based on the total amount of monomers, preferably not more than 5 wt.-%.

Hydrophilic polymers with structural units (A1"), wherein X and AG are as defined above

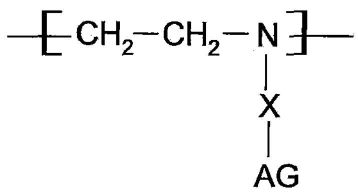

(A1")

can be prepared by polymerizing vinyl amine or ethylene imine (optionally with other monomers) and subsequent Michael addition with an unsaturated monomer comprising an acid group selected from -COOH, $-SO_3H$, $-P_3O_2H_2$ and $-PO_3H_2$; instead of reaction with an unsaturated acid like (meth)acrylic acid, the obtained poly(ethylene)imine or poly(vinyl)amine homopolymer or copolymer thereof with an acrylate or methacrylate comonomer can be reacted with an halogenated acid like 2-chloro-acetic acid or intramolecular cyclic acid anhydrides like maleic acid anhydride.

The synthesis of phosphonic acid derivatives and sulfonic acid derivates of poly(ethylene imine) and poly (vinylamine) is for instance disclosed in EP 490 231 A2.

According to one embodiment the hydrophilic polymer is water-soluble.

In case of vinylamines, the molecular weight of the hydrophilic polymer can be adjusted by the well-known methods of the radical polymerization like polymerization the presence of chain transfer agents like alkyl mercapto compounds. Furthermore, by so called 'living and controlled' radical polymerization as described by K. Matyjaszewski et al. in J. Phys. Org. Chem. 8 (1995) pp. 306 to 315 allows a good control of molecular weight, polydispersity and terminal functionalities.

The hydrophilic polymer is generally present in an amount of 0.01 to 15 wt-% based on the total weight of the finishing solution. The finishing solution preferably contains 0.1 to 5 wt-%, and most preferred 0.3 to 3 wt-% of the hydrophilic polymer.

*Optional Components of the finisher solution*

*Surfactant:*

An optional component of the finisher used in the present invention is a surfactant.

The surfactant is not specifically limited as long as it is compatible with the other components of the finisher and soluble in the finisher solution. The surfactant can be a cationic, an anionic, an amphoteric or a nonionic one.

Examples of anionic surfactants include hydroxyalkanesulfonates, alkylsulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecylphenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctyl-sulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycol monoaliphatic esters, partial esters of sucrose aliphatic acids, partial esters of polyoxyethylenesorbitanaliphatic acid, partial esters of polyoxyethylenesorbitolaliphatic acids, polyethyleneglycolaliphatic esters, partial esters of polyglycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides. Particularly preferred among these nonionic surfactants are polyoxyethylene phenyl ethers and polyoxyethylene-2-naphthyl ethers.

Further, fluorinic and siliconic anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxcylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

Two or more of the above surfactants may be used in combination. The amount of the surfactant (or total amount of surfactants if more than one is used) is not specifically limited but is preferably from 0 to 20 wt-%, more preferably from 0.01 to 8 wt-% based on the total weight of the finisher.

*Water-soluble film forming polymer commonly used in finisher solutions:*

Another optional component of the finisher solution is a water-soluble film forming polymer.

Examples of suitable polymers are gum arabic, pullulan, cellulose derivatives such as hydroxymethyl celluloses, carboxymethylcelluloses, carboxyethylcelluloses or methylcelluloses, starch derivatives like (cyclo)dextrins, poly(vinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins, starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.
The starch used as a starting product for the starch derivatives can be of various origins, it can e.g. be obtained from corn, potatoes, rye, wheat, rice, manioc, tapioca, chestnuts or acorns; corn starch and potato starch are preferred.
Suitable water-soluble polyhydroxy compounds can be represented by the following structure:

$$R^1(CHOH)_nR_2$$

in which n is 4 to 7; and
either (i) $R^1$ is hydrogen, aryl, or $CH_2OH$; and $R^2$ is hydrogen, an alkyl group having 1 to 4 carbon atoms, $CH_2OR^3$ in which $R^3$ is hydrogen or an alkyl group having 1 to 4 carbon atoms, $CH_2N(R^4R^5)$ in which $R^4$ and $R^5$ are each independently hydrogen or an alkyl group having 1 to 4 carbon atoms, or $CO_2H$,
or (ii) $R^1$ and $R^2$ together form a carbon-carbon single bond.
In one group of polyhydroxy compounds, $R^1$ is hydrogen or $CH_2OH$ and $R^2$ is hydrogen. In a preferred group of these polyhydroxy compounds, n is 5 or 6. This group includes the sugar alcohols, compounds of the structure $H(CHOH)_nH$, which do not carry a free aldehyde or ketone group and do not show a reducing property. The sugar alcohols may be obtained from natural sources or prepared by hydrogenation of reducing sugars. Preferred sugar alcohols include mannitol, sorbitol, xylitol, ribitol, and arabitol. Other sugar alcohols include, for example, talitol, dulcitol, and allodulcitol.
In another group of polyhydroxy compounds, $R^1$ and $R^2$ together form a carbon-carbon single bond. Included are carbocyclic compounds of the structure: $(CHOH)_n$, in which n is 4 to 7. In a preferred group of these polyhydroxy compounds, n is 5 or 6, more preferably 6. There are nine possible stereoisomers of 1,2,3,4,5,6-hexahydroxycyclohexane, several of which are naturally occurring. A preferred polyhydroxy compound is meso-inosit (cis-1,2,3,5-trans-4,6-hexahydroxycyclohexane). meso-Inosit can be isolated from corn steep liquor.
In another group of polyhydroxy compounds, $R^1$ is hydrogen, aryl, or $CH_2OH$; and $R^2$ is an alkyl group having 1 to 4 carbon atoms, $CH_2OR^3$ in which $R^3$ is an alkyl group having 1 to 4 carbon atoms, $CH_2N(R^4R^5)$ in which $R^4$ and $R^5$ are each independently H or an alkyl group having 1 to 4 carbon atoms, or $CO_2H$.
In another group of polyhydroxy compounds, $R^1$ is hydrogen or $CH_2OH$; and $R^2$ is $CO_2H$. More preferably, $R^1$ is H and n is 4 or 5. This group includes polyhydroxy compounds of the structure $H(CHOH)_nCO_2H$, in which n is 4 or 5. Conceptually, these polyhydroxy compounds may be produced by oxidation of the corresponding hexose or pentose sugar, i.e., oxidation of the aldehyde group of a hexose sugar such as glucose, galactose, allose, mannose, etc., or oxidation of the aldehyde of a pentose sugar such as arabinose, ribose, xylose, etc.
Particularly preferred polyhydroxy compounds are the sugar alcohols mentioned above, like sorbitol.
The amount of the film forming polymer is not specifically limited; preferably it is from 0 to 30 wt-% based on the total weight of the finisher solution, more preferably from 1 to 20 wt-%.

*Further optional components of the developer:*

Besides the above-cited optional components the finisher solution used in the present invention may contain further additives like organic solvents, biocides, complexing agents, buffer substances, dyes, antifoaming agents, odorants, anticorrosive agents, thickening agents, acidic and alkaline components.

Antifoaming agents:

Suitable antifoaming agents include e.g. the commercially available Silicone Antifoam Emulsion SE57 (Wacker), TRITON® CF32 (Rohm & Haas), AKYPO® LF (ethercarboxylic acid Chem Y), Agitan 190 (Münzing Chemie), TEGO® Foamese 825 (modified polysiloxane, TEGO Chemie Service GmbH, Germany). Silicone-based antifoaming agents are preferred. They are either dispersible or soluble in water. The amount of antifoaming agent in the developer is preferably 0 to 1 wt-%, based on the weight of the finisher solution especially preferred 0.01 to 0.5 wt-%. One antifoaming agent or a mixture of two or more can be used.

Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benzisothiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof Their amount is not particularly restricted and preferably accounts for 0 to 10 wt-%, based on the total weight of the finisher solution, especially preferred 0.1 to 1 wt-%. One biocide or a mixture of two or more can be used.

Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraaminohexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic acid and potassium or sodium salts thereof, and an organophosphonic acid, phosphonoalkane tricarboxylic acid or salts thereof, such as 2-phosphonobutane-1,2,4-tricarboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylene-phosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the finisher solution, based on the total weight of the solution, especially preferred 0.01 to 1 wt-%.

Solvents:

The developer may also comprise an organic solvent or a mixture of organic solvents. The developer is a single phase. Consequently, the organic solvent must be miscible with water, or at least soluble in the developer to the extent it is added to the developer, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the finisher solution at a concentration of between about 0 wt-% to about 15 wt-%, based on the weight of the finisher solution preferably between about 3 wt-% and about 5 wt-%, based on the weight of the finisher solution.

Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula

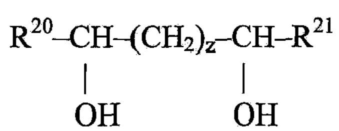

(wherein z is 0, 1 or 2 and $R^{20}$ and $R^{21}$ are independently hydrogen or $C_1$-$C_3$ alkyl).

The anticorrosive agent or mixture of such agents is typically present in the finisher solution at a concentration of about 0 to 10 wt-% based on the weight of the finisher solution, preferably 0.1 to 5 wt-%, in case of glycerol or a glycol 5 to 10 wt-%.

Further additives:

Odorants and dyes can also be present in the finisher solution, if desired. The dyes are added in order to prevent confusion when different processing chemicals like developer, replenisher and finisher are used at the same time. Examples for classes of dyes that can be used are azo dyes, triarylmethan dyes or phthalocyanines. The concentration of the dyes in the finisher solution is typically 0 to 1 wt.-%, preferably 0.0005 to 0.5 wt.-% based on the finisher solution.

Odorants are used in order to compensate unpleasant smell of other components in the finisher solution. The typical concentration of odorants is within 0.001 to 1 wt.-% based on the finisher solution.

The present invention is described in more details in the following examples; however, they are not intended to restrict the invention in any way.

**Examples**

The following abbreviations are used:

| | |
|---|---|
| Desmodur® 100 | trifunctional isocyanate (biuret of hexamethylene diisocyanate), available from Bayer |
| Basonyl Violet 610 | triarylmethane dye from BASF (AG) |
| HEA | (2-hydroxyethyl)acrylate |
| HEMA | (2-hydroxyethyl)methacrylate |
| HEPi | 2-(2-hydroxyethyl)-piperidine |
| HMDI | hexamethylene diisocyanate |
| Ioncryl 683 | acrylic resin available from SC Johnson & Son Inc. USA, acid number = 162 mg KOH/g |
| IR dye 66e | IR absorbing cyanine dye from FEW Chemicals GmbH |

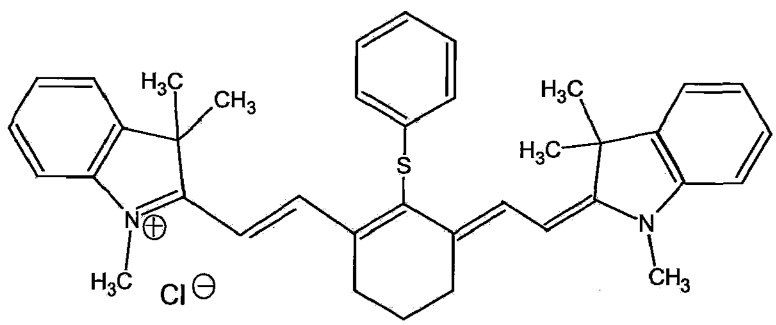

| | |
|---|---|
| Kayamer PM-2 | ester of 1 mol phosphoric acid and 1.5 mol hydroxyethylmethacrylate, available from Nippon Kayaku |
| NEKAL® Paste | anionic surfactant (alkylnaphthalene sulfonic acid, sodium salt), available from BASF |
| NK Ester BPE 500 | ethoxylated Bisphenol A dimethacrylate from Shin Nakamura Ltd. |
| NK Ester BPE-200 | ethoxylated Bisphenol A dimethacrylate from Shin Nakamura Ltd. |
| PETA | pentaerythritol triacrylate |
| PC1199 | ethoxylated/propoxylated C10-C12 alcohol from Polygon |
| Renolblue B2G-HW® | copper phthalocyanine pigment dispersed in polyvinyl butyral from Clariant |
| REWOPOL® NLS 28 | available from REWO |
| Blaunon-B13 | Available from Marwood Chemicals |
| TEXAPON® 842 | available from Henkel |
| PIG 911 | Copper phthalocyanine dispersion, 10 % in Dowanol PM |
| Mikuni cyan | copper phthalocyanine pigment, 23 wt.% in Dowanol PM, available from Mikuni |
| Violet 500 plate developer | commercially available developer for UV plates, available from Kodak |
| 980 Thermal plates developer | commercially available developer for thermal plates, available from Kodak |

**Examples 1-20 and Comparative Examples 1-4**

An electrochemically roughened and anodized aluminum foil with an oxide weight of 2.5 $g/m^2$ was coated with a radiation-sensitive coating solution as shown in Table 1 (combined with Tables 2 to 6) after filtering the solution. The

sample was dried for 4 minutes at 90˚C.

The obtained plates #1 to #5 were overcoated with an aqueous solution of poly(vinyl alcohol) (Celvol 203 from Air Products, having a hydrolysis degree of 88%) to get a printing plate precursor having a dry coating weight of the overcoat as summarized in Table 1 after drying for 4 minutes at 90˚C.

**Table 1 Plates for examples and comparative examples**

| plate no. | Photo-polymer layer | coating weight of the photopolymer layer | coating weight of the overcoat layer | exposure step | preheat step | developer |
|---|---|---|---|---|---|---|
| 1 | Table 2 | 1.7 g/m$^2$ | 2.5 g/m$^2$ | 405 nm (30 mW) platesetter ANDROMEDA from Lithotech | 90˚C for 2 minutes | Violet 500 Plate developer |
| 2 | Table 3 | 1.7 g/m$^2$ | 2.0 g/m$^2$ | Trendsetter 3244 from Creo (830 nm, 40 to 90 mJ/cm$^2$) | 90˚C for 2 minutes | 980 Thermal Plate Developer |
| 3 | Table 4 | 1.7 g/m$^2$ | 0.6 g/m$^2$ | Trendsetter 3244 from Creo (830 nm, 40 to 90 mJ/cm$^2$) | - | 980 Thermal Plate Developer |
| 4 | Table 5 | 1.5 g/m$^2$ | 3 g/m$^2$ | 405 nm (30 mW) platesetter ANDROMEDA from Lithotech | - | Violet 500 Plate developer |
| 5 | Table 6 | 2.0 g/m$^2$ | 2.0 g/m$^2$ | Theimer vacuum frame equipped with Ga-doped Hg-lamp | 90˚C for 2 minutes | 980 Thermal Plate Developer |

**Table 2 Composition of photopolymer layer of plate #1 sensitized to 405nm**

| | |
|---|---|
| 6.48 g | copolymer made of methyl methacrylate and methacrylic acid dissolved in propylene glycol monomethyl ether resulting in a 27.9 wt% solution exhibiting an acid number of 85 |
| 1.12 g | of a dispersion in propylene glycol monomethyl ether containing 7.25 wt% of copper phthalocyanine and 7.25 wt% of a polyvinylacetal binder containing 39.9 mol% vinyl alcohol, 1.2 mol% vinylacetate, 15.4 mol% acetal groups from acetaldehyde, 36.1 mol% acetal groups from butyraldehyde and 7.4 mol% acetal groups from 4-formylbenzoic acid |
| 0.08 g | Kayamer PM-2 |
| 10.98 g | a solution of 30 weight% in methyl ethyl ketone of an oligomer made by reaction of HMDI + HEMA + HEPi |
| 0.6 g | NK Ester BPE 500 |
| 1.12 g | 2-phenyl-4-(2-chlorophenyl)-5-(4-diethylaminophenyl)-oxazole |
| 0.273 g | 2,2-bis-(-2-chlorophenyl)-4,5,4’,5’-tetraphenyl-2’H-[1,2’]biimidazolyl |
| 0.497 g | mercapto-3-triazol |

(continued)

| | |
|---|---|
| 36 ml | propylene glycol monomethyl ether |
| 24 ml | methanol |
| 29 ml | methyl ethyl ketone |

**Table 3 Composition of photopolymer layer of plate #2 sensitized to 810...830 nm**

| | |
|---|---|
| 4.26 g | of a 30% propylene glycol mono methyl ether solution of a terpolymer prepared by polymerization of 470 parts by wt. styrene, 336 parts by wt. methyl methacrylate and 193 parts by wt. methacrylic acid |
| 1.26 g | Ioncryl 683 |
| 9 g | a solution of 30 weight% in methyl ethyl ketone of an oligomer made by reaction of Desmodur® N100 with 1 mol poly (propyleneglycol) methacrylate and 2 mol glycerole dimethacrylate |
| 0.10 g | anilino diacetic acid |
| 0.30 g | 2-(4-methoxyphenyl)4.6-trichlormethyl-1,3,5-triazin |
| 1.5 g | Pigment solution (MIKUNI cyan, 20 wt-%) |
| 0.021 g | phosphoric acid (85%) |
| 0.09 g | IR dye 66e |
| 0.33 g | 5-(4-Vinylbenzyl) thio-1,3,4-thiadiazole-2-thiole |
| 30 ml | propylene glycol monomethyl ether |
| 3 ml | acetone |

**Table 4 Composition of non preheat photopolymer layer of plate #3 sensitized to 810...830 nm**

| | |
|---|---|
| 2.92 g | of a copolymer prepared by the reaction of 20 mol% methacrylic acid and 80 mol% allyl methacrylate |
| 3.93 g | a solution of 30 weight% in methyl ethyl ketone of an oligomer made by reaction of Desmodur N100 with 1 mol poly (propyleneglycol) methacrylate and 2 mol glycerole dimethacrylate |
| 1.18 g | NK Ester BPE-200 |
| 0.10 g | anilino diacetic acid |
| 0.15 g | 2-(4-methoxyphenyl)4.6-trichlormethyl-1,3,5-triazin |
| 1.5 g | Pigment solution (MIKUNI cyan, 20 wt-%) |
| 0.02 g | phosphoric acid (85%) |
| 0.09 g | IR dye 66e |
| 0.12 g | 5-(4-vinylbenzyl) thio-1,3,4-thiadiazole-2-thiole |
| 0.18 g | Kayamer PM-2 |
| 38 ml | propylene glycol monomethyl ether |
| 4 ml | 2-butanone |

**Table 5 Composition of non preheat photopolymer layer of plate #4 sensitized to 405 nm**

| | |
|---|---|
| 1.62 g | a copolymer made of allyl methacrylate and methacrylic acid with an acid number of 55 |
| 0.28 g | of a dispersion in propylene glycol mono methyl ether containing 7.25 wt% of copper phthalocyanine and 7.25 wt% of a polyvinylacetal binder containing 39.9 mol% vinyl alcohol, 1.2 mol% vinylacetate, 15.4 mol% acetal groups from acetaldehyde, 36.1 mol% acetal groups from butyraldehyde and 7.4 acetal groups from 4-formylbenzoic acid |
| 0.02 g | Kayamer PM-2 |
| 0.2 g | butyl-3-methyl-imidazolium tetrafluoroborat |
| 2.745 g | of a 80% methyl ethyl ketone solution of an urethane acrylate prepared by reacting Desmodur N 100® (available from BAYER, Germany) comprising hydroxy ethyl acrylate and pentaerythritol triacrylate having a double-bond content of 0.5 double bonds/100 g when all isocyanate groups are completely reacted with the hydroxy group containing acrylates |
| 0.15 g | NK Ester PBE-500 |
| 1.1 g | 2-phenyl-4-(2-chlorophenyl)-5-(4 .diethylaminophenyl)-oxazole |
| 0.27 g | 2,2-bis-(-2-chlorophenyl)-4,5,4',5'-tetraphenyl-2'H-[1,2']biimidazolyl |
| 0.12 g | 3-mercapto-1,2,4-triazol |
| 9 g | propylene glycol monomethyl ether |
| 6 g | methanol |
| 7.25 g | butanone |

**Table 6: Composition of near UV sensitive photopolymer layer of plate #5**

| | |
|---|---|
| 2.1 g | of a terpolymer prepared by polymerization of 476 parts by wt. styrene, 476 parts by wt. methyl methacrylate and 106 parts by wt. methacrylic acid |
| 5.24 g | of a 80% methyl ethyl ketone solution of an urethane acrylate prepared by reacting Desmodur N 100® (available from BAYER, Germany) comprising hydroxyethyl acrylate and pentaerythritol triacrylate having a double-bond content of 0.5 double bonds/100 g when all isocyanate groups are completely reacted with the hydroxy group containing acrylates |
| 1.29 g | dipentaerythritolpentaacrylate |
| 0.6 g | 2,4-trichloromethyl-6[(4-ethoxyethylenoxy)naphthyl]1,3,5-triazine |
| 0.16 g | 4,4'-N,N-diethylaminobenzophenone |
| 0.2 g | benzophenone |
| 0.19 g | 3-mercapto-1,2,4-triazol |
| 0.12 g | Renolblue B2G-HW |
| 0.1 g | Leuco-crystal violet |

**Laser exposure of plates #2 and #3 at 830 nm:**

The UGRA/FOGRA Postscript Strip version 2.0 EPS (available from UGRA), which contains different elements for evaluating the quality of the copies, was used for imaging plates #2 and #3 with Trendsetter 3244 from Creo (830nm). Plate #2 was heated directly after exposure for 2 minutes to 90˚C.

**Laser exposure of plates #1 and #4 at 405 nm:**

The printing plates #1 and #4 were exposed with an image-setter (Andromeda® A750M from Lithotech), equipped with a laser diode emitting at 405 nm (P= 30 mW). An UGRA gray scale V2.4 with defined tonal values (all data were linearized in order to approximately obtain the desired tonal value) was exposed onto the plate precursor described above. Plate #1 was heated directly after exposure for 2 minutes to 90˚C.

**Exposure of plate #5:**

The printing plate #5 was exposed with a Theimer vacuum frame equipped with a Ga-doped Hg-lamp in contact with UGRA Offset test scale 1982. The plate was heated directly after exposure for 2 minutes to 90˚C.

**Development and finishing treatment of the plates:**

The plates were developed in a MercureyNews85 (Kodak) processor equipped with 2 scrub brush rollers with the developers as shown in Table 1 and treated with the plate finishers as summarized in Table 7. The developing temperature was 23˚C and the developer dwell time was 20 seconds. The plate was then rinsed until all developer residuals were removed. The temperature of the finisher bath was 23 ˚C. The plate was finally dried at 40-60˚C in the finisher section.

**Table 7 Compositions of the finishers used**

| Finisher | Components | Amounts |
|---|---|---|
| F1 | Water<br>LUPASOL PN 60 | 95 wt-%<br>5 wt-% |
| F2 | Boraxdextrin Emdex RT 253NVP1)<br>Preventol ON extr2)<br>Dowfax 83903)<br>Sequion 20 H454)<br>Water<br>LUPASOL PN 60 | 3 wt-%<br>0.2 wt-%<br>0.5 wt-%<br>0.02 wt-%<br>95.28 wt-%<br>1 wt-% |
| F3 | Emdex 30 AN 455)<br>Water<br>LUPASOL PN 60 | 3 wt-%<br>95 wt-%<br>2 wt-% |
| F4 | Emdex 30 AN 455)<br>Preventol ON extra2)<br>Dowfax 83903)<br>Sequion 20 H454)<br>Water<br>LUPASOL PN 60 | 6 wt-%<br>0.3 wt-%<br>0.4 wt-%<br>0.01 wt-%<br>92.29 wt-%<br>1 wt-% |
| CF1 | Water | 100 wt-% |
| CF2 | Boraxdextrin Emdex RT 253NVP1)<br>Preventol ON extra2)<br>Dowfax 83903)<br>Sequion 20 H454)<br>Water | 3 wt-%<br>0.2 wt-%<br>0.5 wt-%<br>0.02 wt-%<br>96.28 wt-% |
| CF3 | Emdex 30 AN 455)<br>Water | 3 wt-%<br>97 wt-% |
| CF4 | Emdex 30 AN 455)<br>Preventol ON extra2)<br>Dowfax 83903)<br>Sequion 20 H454) | 6 wt-%<br>0.3 wt-%<br>0.4 wt-%<br>0.01 wt-% |

(continued)

| Finisher | Components | Amounts |
|---|---|---|
| | Water | 93.29 wt.-% |

1) Boraxdextrin: Dextrin produced by hydrolysis of potato starch; it comprises 5 to 10 wt.-% sodium tetraborate; available from Emsland Stärke GmbH/Emlichheim, Germany
2) Sodium 2-phenyl-phenolate; available from Bayer AG
3) n-Hexadecyl-diphenyloxide disulfate sodium salt; available from Dow
4) Amino-trimethylene-phosphonic acid; available from Dow
5) Dextrin, produced by hydrolysis of potato starch, available from Emsland Stärke GmbH

**Printing of the plates:**

The thus prepared plates were loaded in a sheet-fed offset printing machine using abrasive ink (Offset S 7184 available from Sun Chemical which contains 10% of calcium carbonate). The image free areas were checked for toning. Up to 100 000 copies were made but, unless noted otherwise, the print run could have continued.

The following tests were carried out in order to compare the new finishers (F1-F4) with water and commonly used the finisher solutions (CF1-CF4

**Roll-up**

The number of sheets required before a clean image was printed was counted. When less than 20 sheets were needed, the performance was considered satisfactory. The results are shown in Table 8.

**Toning on press**

The image free parts were inspected after completion of the print job whether it took ink or not. The results are shown in Table 8.

**Table 8 Results of Examples 1 to 20 and Comparative Examples 1 to 7**

| | finisher | plate number | roll-up | toning on press | length of run |
|---|---|---|---|---|---|
| Example 1 | F1 | 1 | <20 | no | >100000 |
| Example 2 | F1 | 2 | <20 | no | >100000 |
| Example 3 | F1 | 3 | <20 | no | >100000 |
| Example 4 | F1 | 4 | <20 | no | >100000 |
| Example 5 | F1 | 5 | <20 | no | >100000 |
| Example 6 | F2 | 1 | <20 | no | >100000 |
| Example 7 | F2 | 2 | <20 | no | >100000 |
| Example 8 | F2 | 3 | <20 | no | >100000 |
| Example 9 | F2 | 4 | <20 | no | >100000 |
| Example 10 | F2 | 5 | <20 | no | >100000 |
| Example 11 | F3 | 1 | <20 | no | >100000 |
| Example 12 | F3 | 2 | <20 | no | >100000 |
| Example 13 | F3 | 3 | <20 | no | >100000 |
| Example 14 | F3 | 4 | <20 | no | >100000 |
| Example 15 | F3 | 5 | <20 | no | >100000 |

(continued)

| | finisher | plate number | roll-up | toning on press | length of run |
|---|---|---|---|---|---|
| Example 16 | F4 | 1 | <20 | no | >100000 |
| Example 17 | F4 | 2 | <20 | no | >100000 |
| Example 18 | F4 | 3 | <20 | no | >100000 |
| Example 19 | F4 | 4 | <20 | no | >100000 |
| Example 20 | F4 | 5 | <20 | no | >100000 |
| Comparative Example 1 | CF1 | 1 | >50 | yes | Discontinued after 2000 impressions because of strong toning |
| Comparative Example 2 | CF1 | 2 | >50 | yes | Discontinued after 2000 impressions because of strong toning |
| Comparative Example 3 | CF1 | 3 | >50 | yes | Discontinued after 2000 impressions because of strong toning |
| Comparative Example 4 | CF1 | 4 | >50 | yes | Discontinued after 2000 impressions because of strong toning |
| Comparative Example 5 | CF2 | 1 | >50 | yes | Discontinued after 2000 impressions because of strong toning |
| Comparative Example 6 | CF3 | 2 | >50 | yes | Discontinued after 2000 impressions because of strong toning |
| Comparative Example 7 | CF4 | 5 | >50 | yes | Discontinued after 2000 impressions because of strong toning |

In examples 1-20, where finishers F1 to F4 were used in the gumming section of the processor, showed good roll-up behaviour and no toning on press at print start or restart. although the substrates had been coated directly with the radiation-sensitive compositions without an interlayer. For the plates of Comparative examples 1-7 using finishers without the specific hydrophilic polymer, toning on press was observed and the roll-up behaviour was unsatisfactory.

**Examples 21-25 and Comparative Examples 8 and 9**

An electrochemically roughened and anodized aluminum foil with an oxide weight of 2.5 $g/m^2$ was provided with a polyvinyl phosphonic acid interlayer of 10 $mg/m^2$. The substrate obtained was then coated with the photopolymer layer as defined in Table 9 (combined with Table 2 and Table 3), respectively. The samples were dried for 4 minutes at 90˚C. The obtained samples were overcoated with an aqueous solution of poly(vinyl alcohol) (Celvol 203 from Air Products, having a hydrolysis degree of 88%) to get a printing plate precursor having a dry coating weight summarized in Table 1 after drying for 4 minutes at 90˚C.

The samples were exposed in different ways dependent on the type of photopolymer layer as described above for Examples 1-20.

The samples were preheated directly after exposure at 90˚C for 2 minutes.

The plates were developed as described above for Examples 1-20.

The plates were then baked at 270 ˚C for 4 mins, treated with the plate finisher as shown in Table 9 (combined with Table 7) at room temperature and dried at 40-60˚C .

Baking is known in the art as to improve the print run lengths of some types of photopolymer layers, it can, however, have a negative effect on the oxide layer of the substrate resulting in severe toning problems. Plates #6 and 7 show good printing performance (roll-up, and toning) without baking, however, their print run length without baking

does not meet the requirements of all printers; therefore, printers often subject the plates to a baking treatment which improves the print run length, however, affects roll-up and toning behaviour.

**Printing of the plates**

The thus prepared plates were loaded in a sheet-fed offset printing machine using abrasive ink (Offset S 7184 available from Sun Chemical which contains 10% of calcium carbonate). The image free areas were checked for toning. Up to 100 000 copies were made but, unless noted otherwise, the print run could have continued. The results are shown in Table 9.

**Table 9 Results of Examples 21 to 25 and Comparative Examples 8 and 9**

| | Plate no. | Photo-polymer | finisher | roll-up | toning on press | length of run |
|---|---|---|---|---|---|---|
| Example 21 | 6 | Table 2 | F1 | <25 | no | >100000 |
| Example 22 | 7 | Table 3 | F2 | <25 | no | >100000 |
| Example 23 | 7 | Table 3 | F2 | <25 | no | >100000 |
| Example 24 | 7 | Table 3 | F3 | <25 | no | >100000 |
| Example 25 | 7 | Table 3 | F4 | <25 | no | >100000 |
| Comparative Example 8 | 6 | Table 2 | CF1 | >100 | yes | Discontinued after 1000 impressions because of strong toning which did not disappear |
| Comparative Example 9 | 7 | Table 3 | CF2 | >100 | yes | Discontinued after 1000 impressions because of strong toning which did not disappear |

The following results are apparent from Table 9:

Although plates #6 and #7 comprised an interlayer (which was not the case for plates #1 to #5) the roll-up behaviour and toning observed for Comparative Examples 8 and 9 was unsatisfactory, i.e. even worse than in Comparative Examples 1 and 6. Contrary thereto, by using a finisher treatment according to the present invention excellent roll-up behaviour and absence of toning problems were observed in Examples 21 to 25. This demonstrates that by the use of the specific type of hydrophilic polymer in the finisher solution is even possible to repair an oxide layer of the substrate somewhat destroyed by baking.

In another experiment no finishing treatment was carried out but LUPASOL PN 60 was added to the fountain solution used for printing. We found that in case of a plate without interlayer the plate showed scumming on press, i.e. no satisfied clean up. This means that plates with such substrates must be treated with a finisher solution according to this invention before the plates are used on the press machine in order to avoid scumming.

**Claims**

**1.** Process for the production of a lithographic printing plate, comprising

(a) providing a lithographic printing plate precursor comprising (i) a substrate; (ii) a radiation-sensitive coating comprising one or more layers and (iii) optionally an oxygen-impermeable overcoat;
(b) image-wise exposing the lithographic printing plate precursor to radiation of a wavelength to which the radiation-sensitive coating is sensitive;
(c) optionally subjecting the image-wise exposed precursor to a preheat treatment and/or rinsing with water;
(d) removing the non-image areas from the image-wise exposed precursor by means of an alkaline developer solution;
(e) optionally subjecting the imaged precursor obtained in step (d) to rinsing with water;

(f) treating the imaged lithographic printing plate obtained in step (d) or (e) with a finisher solution; and
(g) optionally subjecting the finisher treated plate obtained in step (f) to at least one further process step selected from rinsing with water, drying and baking;

**characterized in that** the finisher solution comprises 0.01 to 15 wt.%, based on the total weight of the finisher, of a hydrophilic polymer comprising:

(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50.

**2.** Process for the production of a lithographic printing plate, comprising

(a) providing a substrate;
(b) image-wise applying a composition oleophilic in the dry state, resulting in printing image areas;
(c) treating the lithographic printing plate obtained in step (b) with a finisher solution; and
(d) optionally subjecting the finisher treated plate obtained in step (c) to at least one further process step selected from rinsing with water, drying and baking;

**characterized in that** the finisher solution comprises 0.01 to 15 wt.%, based on the total weight of the finisher, of a hydrophilic polymer comprising:

(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50.

**3.** Process according to claim 1, wherein the radiation-sensitive coating is sensitive to radiation of a wavelength selected from the range of 250 to 750 nm and imagewise exposure in step (b) was carried out with radiation of the same wavelength selected from the range of 250 to 750 nm.

**4.** Process according to claim 1, wherein the radiation-sensitive coating is sensitive to radiation of a wavelength selected from the range of more than 750 to 1200 nm and the imagewise exposure in step (b) was carried out with radiation of the same wavelength selected from the range of more than 750 to 1200 nm.

**5.** Process according to any one of claim 1 to 4, wherein the amino groups of the hydrophilic polymer are bound to carbon atoms of the polymer backbone either directly or via a spacer, or the acid groups of the hydrophilic polymer are bound to carbon atoms of the polymer backbone either directly or via a spacer, or both kinds of groups are bound to carbon atoms of the polymer backbone either directly or via a spacer.

**6.** Process according to any one of claims 1 to 4, wherein the nitrogen atom of the amino groups of the hydrophilic polymer is part of the polymer backbone.

**7.** Process according to any one of claim 1 to 4, wherein the acid groups of the hydrophilic polymer are bound to the nitrogen atoms of the amino groups via a spacer.

**8.** Process according to claim 6 or 7, wherein the hydrophilic polymer comprises the following structural unit in the backbone:

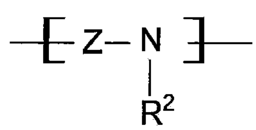

wherein Z is a straight chain or branched $C_1$-$C_3$ alkylene group and $R^2$ represents H, $C_1$-$C_4$ alkyl, phenyl or -X-AG with X being a divalent straight chain or branched hydrocarbon group and -AG representing an acid group as defined

in claim 1.

**9.** Process according to any of claims 1 to 8, wherein the acid groups are -COOH groups.

**10.** Process according to any one of claims 1 to 9, wherein the hydrophilic polymer is present in the finisher solution in an amount of 0.1 to 5 wt% based on the total weight of the finisher solution.

**11.** Process according to any one of claims 1 to 10, wherein the finisher solution further comprises at least one water-soluble film-forming polymer selected from (cyclo)dextrines, gum arabic, pullulan, cellulose derivatives, polyvinyl alcohol, polyvinyl pyrrolidone, and sugar alcohols.

**12.** Process for the posttreatment of an imaged lithographic printing plate comprising

(a) providing a lithographic printing plate comprising image areas and non-image areas on a substrate; .
(b) bringing the lithographic printing plate of step (a) into contact with a finisher solution as defmed in any of claims 1 or 5 to 11.

**13.** Finisher treated lithographic printing plate obtainable by the process according to any of claims 1 to 12.

**14.** Use of a hydrophilic polymer comprising:

(m1) primary, secondary and/or tertiary amino groups, and
(m2) acid groups selected from -COOH, $-SO_3H$, $-PO_2H_2$ and $PO_3H_2$, and
(m3) optionally alkylene oxide units $-(CHR^1-CH_2-O)_p-$, wherein each $R^1$ independently represents H or $-CH_3$ and p is an integer from 1 to 50;

for posttreating a lithographic printing plate comprising image areas and non-image areas on a substrate without interlayer.

European Patent Office

# EUROPEAN SEARCH REPORT

Application Number
EP 07 12 1115

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2006/021447 A (KODAK POLYCHROME GRAPHICS GMBH) 2 March 2006 (2006-03-02)<br>* page 1, line 1 - line 4 *<br>* page 4, line 7 - page 5, line 20 *<br>* page 7; compound II *<br>* page 9, line 23 - page 10, line 4 *<br>* page 11, line 21 - line 28 *<br>* page 12, line 17 - page 13, line 12 *<br>* claims 1-7,11,16,17 *<br>----- | 1-5,7, 10-14 | INV.<br>B41N3/08<br>G03F7/40 |
| A,D | WO 2007/057442 A (AGFA GRAPHICS NV) 24 May 2007 (2007-05-24)<br>* page 1, line 7 - line 17 *<br>* page 6, line 26 - page 7, line 10 *<br>* page 8, line 26 - page 17, line 5 *<br>* page 9, line 15 - line 26 *<br>* page 44, line 34 - page 48, line 26 *<br>* claims 1-19; examples 1-4 *<br>----- | 1-14 | |
| A,D | US 4 880 555 A (J.E.WALLS ET AL.) 14 November 1989 (1989-11-14)<br>* column 2, line 64 - column 3, line 43 *<br>* claims 1-20; example 1 *<br>----- | 1-14 | TECHNICAL FIELDS SEARCHED (IPC)<br>B41N<br>G03F<br>B41C |

The present search report has been drawn up for all claims

| Place of search | Date of completion of the search | Examiner |
|---|---|---|
| The Hague | 22 April 2008 | Bacon, Alan |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT ON EUROPEAN PATENT APPLICATION NO.** EP 07 12 1115

This annex lists the patent family members relating to the patent documents cited in the above-mentioned European search report. The members are as contained in the European Patent Office EDP file on
The European Patent Office is in no way liable for these particulars which are merely given for the purpose of information.

22-04-2008

| Patent document cited in search report | Publication date | Patent family member(s) | Publication date |
|---|---|---|---|
| WO 2006021447 A | 02-03-2006 | CN 101010641 A<br>DE 102004041610 A1<br>EP 1794657 A1 | 01-08-2007<br>16-03-2006<br>13-06-2007 |
| WO 2007057442 A | 24-05-2007 | NONE | |
| US 4880555 A | 14-11-1989 | EP 0359559 A2<br>JP 2108594 A | 21-03-1990<br>20-04-1990 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 2926645 A1
- US 4880555 A
- US 4033919 A
- US 4143021 A
- DE 2504594 A1
- DE 2530502
- WO 2006026230 A
- WO 2006021447 A
- US 5736256 A
- WO 2006056439 A
- EP 490231 A
- WO 2007057442 A
- WO 2007057333 A
- WO 2007057334 A
- WO 2007057335 A
- WO 2007057336 A
- WO 2007057347 A
- WO 2007057348 A
- WO 2007057349 A
- WO 2007057410 A
- EP 0752430 B1
- DE 10307451
- EP 0684522 B1
- DE 19906823 A1
- WO 2004049068 A1
- WO 2004074929 A2
- WO 2004074930 A2
- WO 2004111731 A1
- DE 102004055733
- DE 102004022137 B3
- WO 03069411 A1
- US 6326122 B
- US 4327169 A
- US 4756993 A
- US 5156938 A
- WO 0029214 A
- US 6410207 B
- EP 1176007 A1
- US 5629354 A
- EP 1035435 A1
- US 3445232 A
- WO 2004041544 A
- WO 200048836 A
- DE 102004003143
- DE 4311738 C1
- DE 3332640 A1
- EP 1176007 A2
- DE 19936331
- WO 2004014652 A1
- WO 8906659 A1
- DE 2903270 A1
- WO 9512147 A
- EP 410242 A
- US 4035321 A
- EP 0104863 A
- EP 0625728 B1
- EP 0938413 B1
- US 5965319 A
- US 5919601 A
- WO 0017711 A1
- US 4594306 A
- EP 825927 B1
- WO 9842507 A
- EP 0823327 A
- WO 9901795 A
- WO 9901796 A
- WO 9739894 A
- US 6320018 B
- US 20020150833 A1
- US 6537735 B
- US 6352812 B
- US 6352811 B
- US 6358669 B
- WO 0214071 A
- WO 9906890 A
- US 3458311 A
- US 4072527 A
- US 4072528 A
- EP 275147 A1
- EP 403096 A1
- EP 354475 A1
- EP 465034 A1
- EP 352630 A1
- EP 490231 A2

### Non-patent literature cited in the description

- **D. W. VAN KREVELEN.** Properties of Polymers: Their Correlation with Chemical Structure; Their Numerical Estimation and Prediction From Additive Group Contributions. Elsevier, 2003

- **D. W. VAN KREVELEN.** Properties of Polymers. Elsevier, 2003
- **K. MATYJASZEWSKI et al.** *J. Phys. Org. Chem.,* 1995, vol. 8, 306-315